# EUROPEAN PATENT SPECIFICATION

(11) **EP 0 244 950 B1**
(45) Date of publication and mention of the grant of the patent: **09.11.1994**
(21) Application number: 87302957.3
(22) Date of filing: 03.04.1987
(51) Int. Cl.: H01L 21/00

(54) **Method and apparatus for handling and processing wafer-like materials**
Verfahren und Vorrichtung zur Handhabung und Behandlung von scheibenartigen Materialien
Méthode et appareil de manipulation et de traitement de matériaux en forme de disque

(30) Priority: 04.04.1986 US 848297
(43) Date of publication of application: 11.11.1987
(73) Proprietor: MATERIALS RESEARCH CORPORATION, Orangeburg New York 10962 (US)
(72) Inventor: Eror, Miroslav, Old Tappan New Jersey 07675 (US); Biehl, Richard E., Pearl River New York 10966 (US)
(74) Representative: Cross, Rupert Edward Blount

(56) References cited:
- EP-A- 0 066 243
- GB-A- 2 131 390
- US-A- 3 823 836
- US-A- 4 416 577
- US-A- 4 501 527
- US-A- 4 548 699
- PATENT ABSTRACTS OF JAPAN vol. 8, no. 198 (E-265)(1635) 11 September 1984 ; & JP-A-5986143

## Description

The present invention relates to a method and apparatus for handling and processing wafer-like articles. In particular, the invention relates to a method and apparatus for handling and processing thin wafers, such as semiconductor substrates. The apparatus of the present invention can be used in systems for such purposes as etching of semiconductor wafer substrates and sputtering of deposits on such substrates.

US-A-3823836 (Cheney et al) discloses an apparatus for handling generally flat sheets such as disks or rectangles of fragile silicon. The apparatus comprises a supply carrier in which there are a plurality of edges designed to hold the sheets at the outermost edges and a discharge carrier similar to the supply carrier capable of receiving the sheets one at a time on ledges. A work station is capable of receiving the sheets and performing the necessary process on the sheets. The sheets are transferred from the supply carrier to the work station by a vertical unload arm which removes the sheets from the supply carrier and a transfer arm which transfers a sheet from the unload arm to the work station. The transfer arm is rotatably mounted on a shaft to rotat 90° and includes a vaccum chuck for holding the sheet. The processed sheet is transferred from the work station to the discharge carrier via an unload arm by which the sheets are transferred to the discharge carrier and a rotatable arm, rotatable by an angle of 90°, which transfers the processed wafer from the work station to the unload arm. A vacuum chuck is provided at the end of the rotatable arm to hold the sheet. Both the transfer arm and the unload arm are mounted to be horizontally rotated.

US-A-4 416 577 discloses a robot hand for industrial application which can be used as engaging means.

US-A-4501527 (Jacoby et al) discloses a device for the automatic transport of disc shaped objects from a discharge cassette adjustable in height through a position adjusting station to an inspection table and further into depository cassettes which are also adjustable in height in a step-wise manner. Transfer of a disc from the discharge cassette to the position aligning station and thence to the inspection table is effected by a pivoting lever. The working process may be accelerated by equipping the pivoting lever with at least two arms of equal length and arranging the discharge cassette, the position aligning station and the inspection table so that a disc may be taken simultaneously from two of the stations such as the position adjusting station and the inspection table.

GB-A-2131390 (Jungheinrich) discloses an automatic handling implement for industrial operations. The apparatus includes a base on which the base plate is rotatably mounted by means of a circular track about a centre line. An upright housing is eccentrically mounted on the base plate. A carrier is rotatably mounted on the housing and is able to rotate about an axle transverse to the centre line. An arm, having two portions of equal length and extending on opposite sides of the carrier, is mounted for rotation about an axis parallel to the axle. Tool heads are carried on each end of the arm and may be mounted so as to have further degress of freedom. The arm is disposed over the vertical axis of rotation of the base plate so that a balanced implement is provided. A stable structure, particularly for providing a weight balance, is required so that the apparatus can operate precisely.

Known designs for wafer processing machinese allow wafers to be processed in vacuum environments.

In a first aspect of the present invention there is provided apparatus, according to claim 1.

In a second aspect of the present invention there is provided a method, according to claim 10.

### BRIEF DESCRIPTION OF THE DRAWINGS

The invention will be described in greater detail in the following detailed description with reference to the drawings, in which:
FIG. 1 is an overall cut-away perspective view of the apparatus according to the invention;
FIG. 2 is a left side partially sectional view of the apparatus of FIG. 1;
FIG. 3 is a front sectional view of the apparatus of FIG. 1;
FIG. 3A is a schematic diagram of the apparatus according to the invention;
FIG. 4 is a more detailed front sectional view of part of the apparatus of FIG. 1, and in particular, that part of the apparatus which transfers unprocessed and processed wafers from or to holding cassettes;
FIG. 5 is a top sectional view of that part of the apparatus shown in FIG. 4;
FIG. 6 shows that part of the apparatus shown in FIG. 4 and illustrates some of the steps of wafer handling before the wafer is introduced into a controlled environment of the apparatus;
FIG. 7 shows the same view as FIG. 6 but shows additional steps of wafer handling and insertion of the wafer into a controlled environment of the apparatus according to the invention;
FIGS. 8 and 9 show further top sectional views of portions of the apparatus shown in FIGS. 4, 5, 6, and 7, and, in particular, those portions of the apparatus and the steps performed thereby directed to centering the wafer on a lifting table and aligning an indexing mark disposed on the perimeter of the wafer on the lifting table;
FIGS. 10 and 11 are sectional views showing parts of the apparatus for transferring a wafer into and out of a controlled environment chamber, and different steps performed by such apparatus;
FIG. 12 shows a top view of a portion of the apparatus for handling the wafer in the controlled environment prior to or after processing of the wafer in the main chamber volume;
FIG. 13 is a side sectional view of a portion of the apparatus shown in FIG. 1, and in particular that portion of the apparatus which relates to handling of the wafer in a controlled environment of the apparatus according to the invention;
FIGS. 14 and 15 show top partially sectional views of the apparatus according to the invention illustrating steps in handling of wafers in the controlled environment before or after processing in the main processing apparatus proper;
FIGS. 15A and 15B show schematically the steps involved in transferring a wafer to and from the wafer processing apparatus proper;
FIG. 16 is a top view of the apparatus according to the invention showing the main processing apparatus in its opened condition;
FIG. 17 is a horizontal sectional top view through the main processing apparatus of the invention taken through section lines 17-17 of FIG. 2;
FIG. 18 is the same view as FIG. 17 but shows the apparatus during a different step in the processing of a wafer;
FIG. 19 is a more detailed vertical sectional view of a portion of the apparatus shown in FIG. 18 taken through section lines 19-19 of FIG. 2;
FIGS. 20 and 21 show partial sectional views of portions of the apparatus for transferring a wafer to and from the main processing portion of the apparatus;
FIG. 22 is a detailed sectional view through a portion of the main processing apparatus showing one processing station according to the apparatus of the invention taken through section lines 22-22 of FIG. 17;
FIG. 23 is a sectional view like that of FIG. 22 showing a different step in the processing of a wafer;
FIG. 24 is a front view of the means for holding a wafer in a rotatable index plate of the main processing apparatus of the invention;
FIG. 25 is a right side view of the apparatus according to the invention;
FIG. 26 is a cut away right side view showing the interior of the main processing apparatus according to the invention; and
FIG. 27 is a rear view of the apparatus according to the invention.

### DETAILED DESCRIPTION

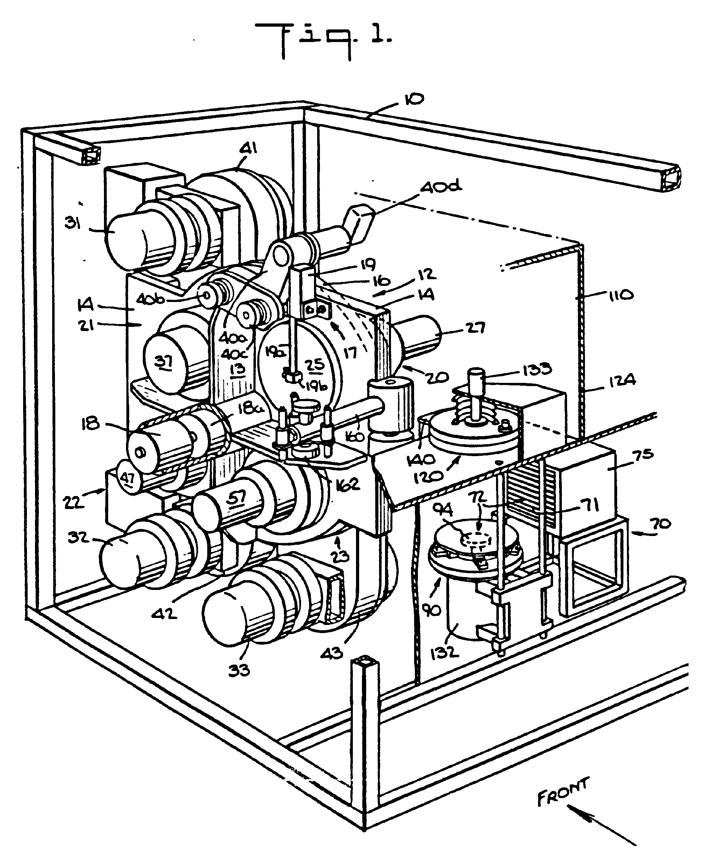

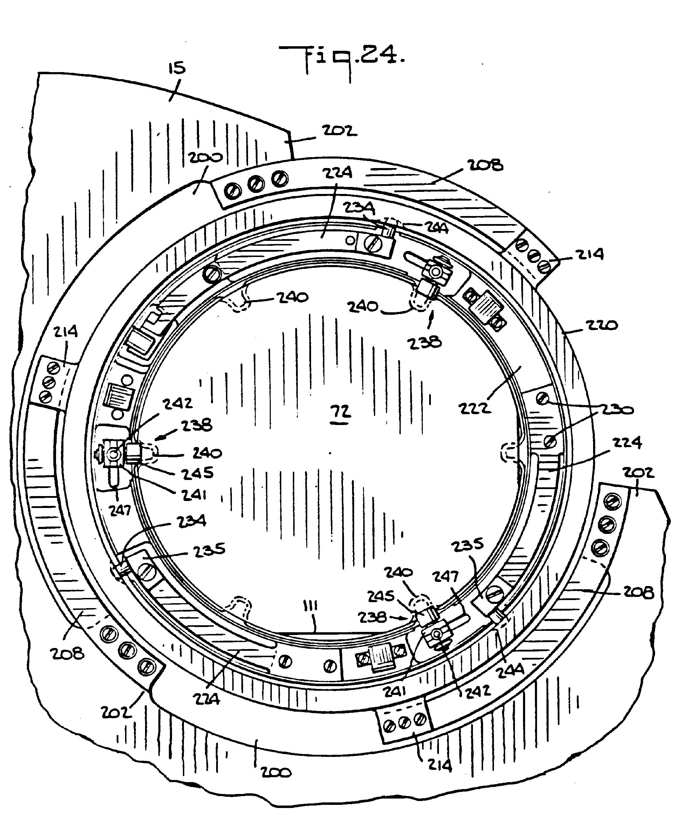

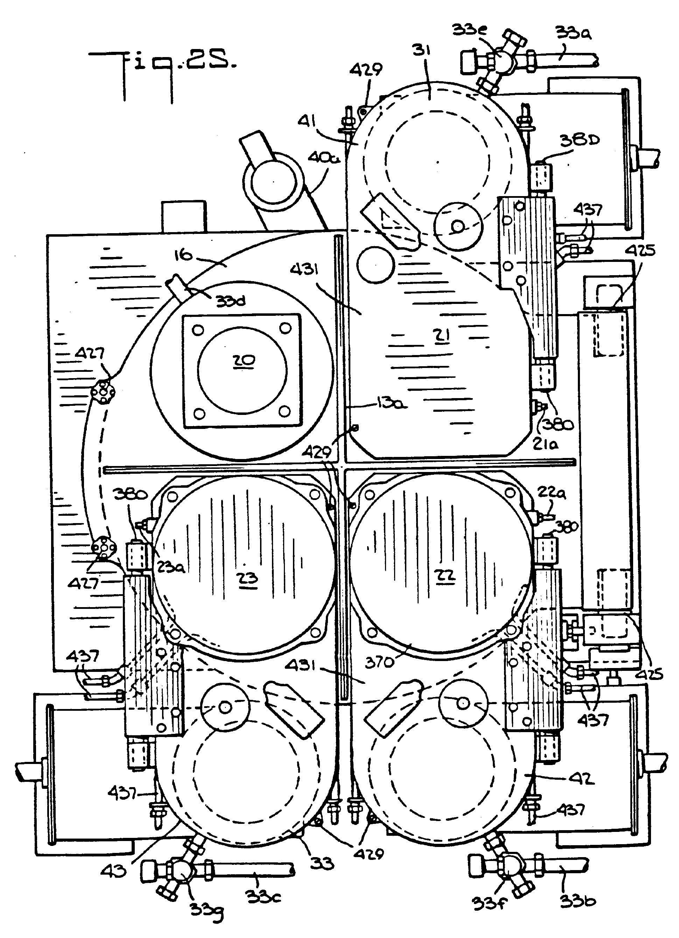

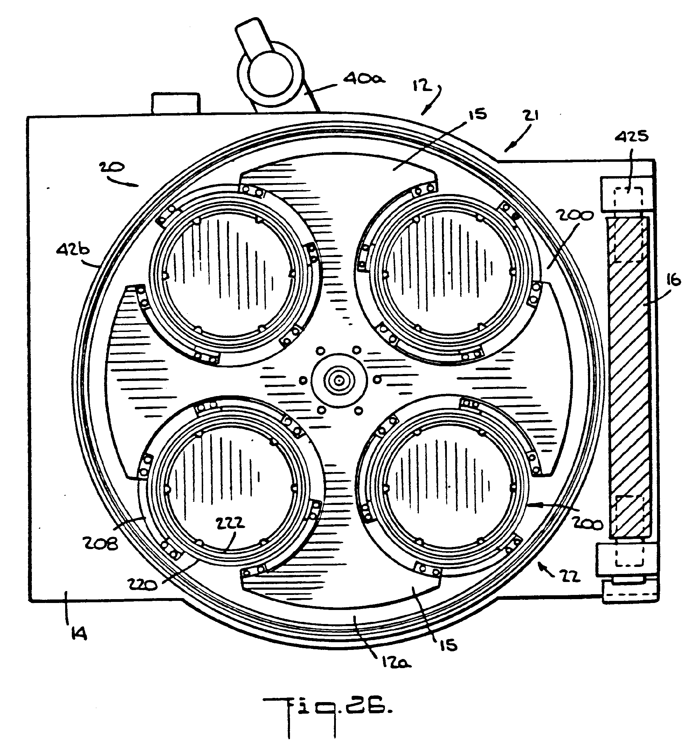

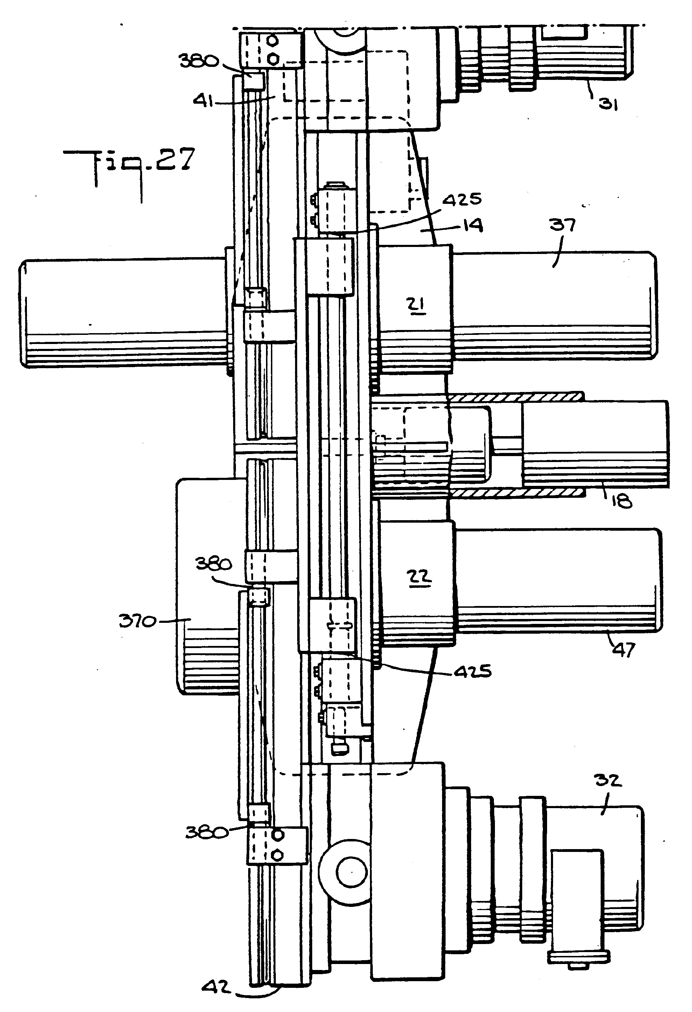

With reference now to the drawings, FIG. 1 shows a perspective view of the apparatus according to the invention. The front of the apparatus is considered to point to the right. The apparatus comprises, generally, a frame 10 to which is mounted a chamber 12, the chamber comprising two approximate half sections 14 and 16. The chamber includes a rotatable index plate 15, shown in greater detail in FIG. 26, which is driven by a motor 18 through a sealing member 18a, which may comprise a ferrofluidic sealing member. Each of the chamber halves 14 and 16 are reinforced by reinforcing structures 13 and 13a, respectively. See FIG. 25. Chamber 12 halves 14 and 16 define a main plenum area 12a, shown in greater detail in FIG. 26. Attached to each of the half sections 14 and 16 of chamber 12 and disposed at equal angular intervals about the center of chamber 12 are the respective portions of four work stations 20, 21, 22 and 23. Station 20 comprises a load-lock station for the entry and removal of processed or unprocessed articles and stations 21, 22 and 23 comprise processing stations wherein various processing steps, such as etching and sputtering, may be carried out. In each work station, a different step may be carried out upon a substrate held by the rotatable index plate 15. Different processes may be simultaneously performed on different substrates at the different stations. In particular, station 20, which comprises the load-lock station, allows substrates to be inserted into or removed from the chamber 12 via a load-lock door 25 actuated by associated door operating mechanism 19, to be explained in greater detail later. Station 21 comprises a station wherein, for example, the substrate may be cleaned or etched to prepare it for further processing in stations 22 and 23, which may, for example, comprise sputtering stations wherein metallic layers are deposited on the substrate. Once a substrate has been rotated in the direction shown by arrow 17 through stations 20 to 23, it is then rotated further to complete a cycle of rotation to station 20, where the processed substrate is then removed through load-lock door 25. The apparatus allows four substrates to be disposed within the machine at any one time, and three different processes may be performed at stations 21, 22 and 23 on three different substrates simultaneously. Although four work stations are shown in the illustrated embodiment, a lesser or greater number of work stations could be provided by suitable modification of the apparatus.

The apparatus further includes a number of vacuum pumps 31, 32, 33 and 40d, which may be cryogenic vacuum pumps, for example, for providing the proper final vacuum levels in each of the volumes of the processing stations 21, 22 and 23 and load-lock station 20, respectively. As will be explained later, the apparatus of the invention allows the work station volumes to be isolated from the main chamber volume 12a during processing. Vacuum pumps 31, 32, 33 and 40d are coupled to the respective stations by respective manifold members 41, 42, 43 and 40a. Before cryogenic pumps 31, 32, 33 and 40d are activated, separate mechanical vacuum pumps connected to suitable fittings 33a, 33b, 33c, and 33d are activated to evacuate the respective chambers to a level close to the desired vacuum level. See FIG. 25. Cryogenic pumps 31, 32, 33 and 40d then are activated to bring the vacuum down to the desired levels. As shown in FIG. 25, fittings 33a, 33b and 33c include suitable valve members 33e, 33f and 33g, respectively, for disconnecting the mechanical vacuum sources from the respective processing chambers 21, 22 and 23, respectively.

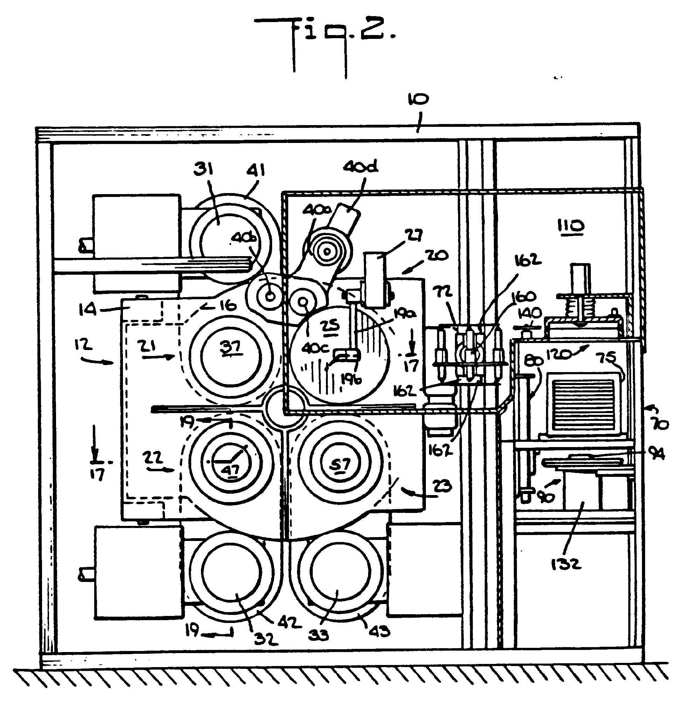

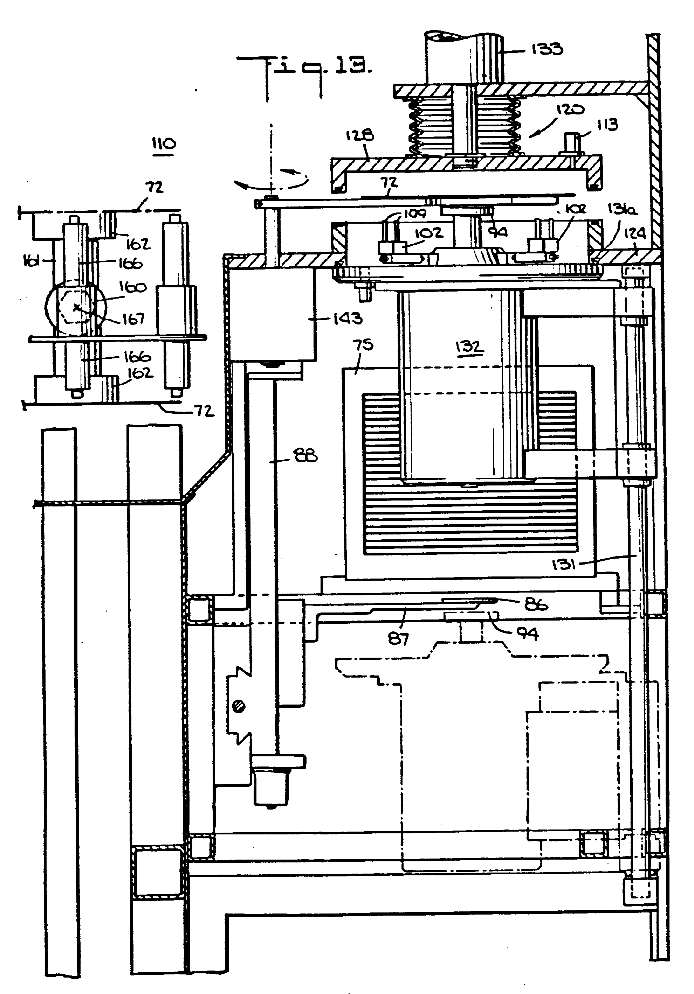

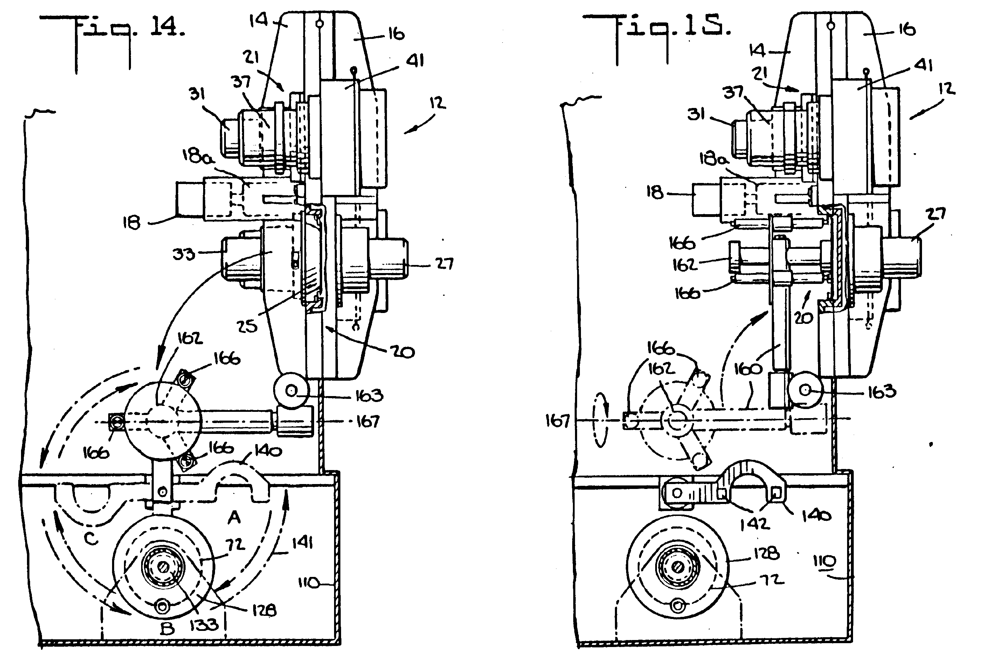

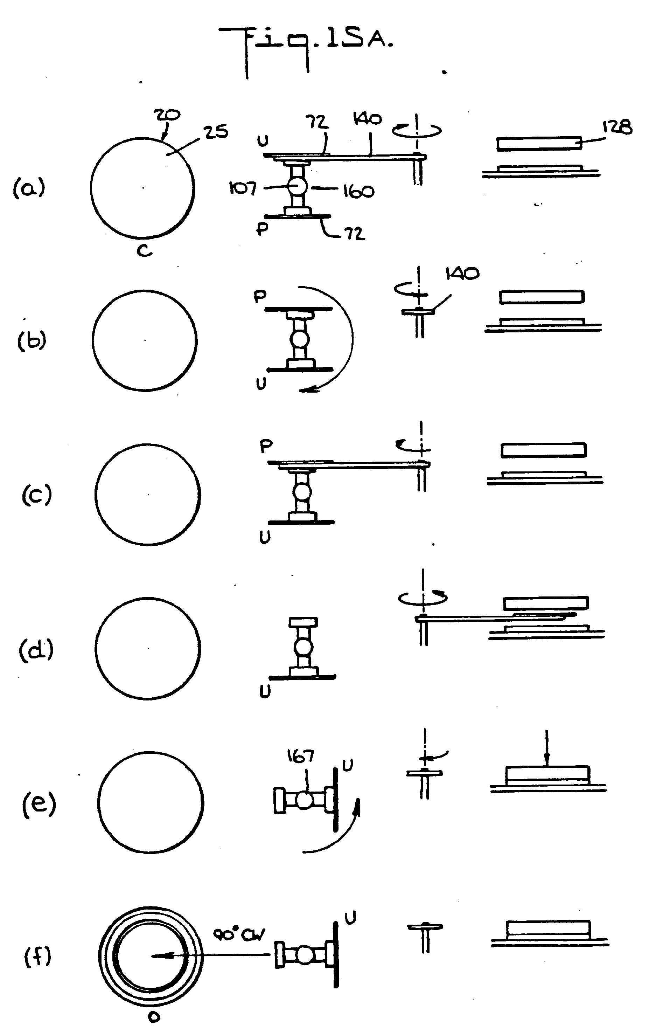

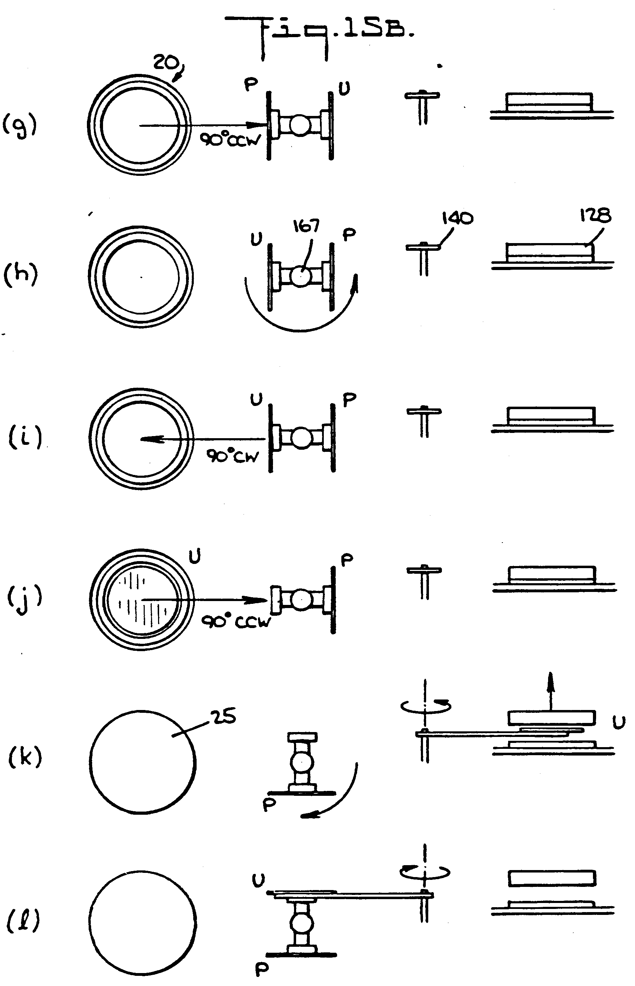

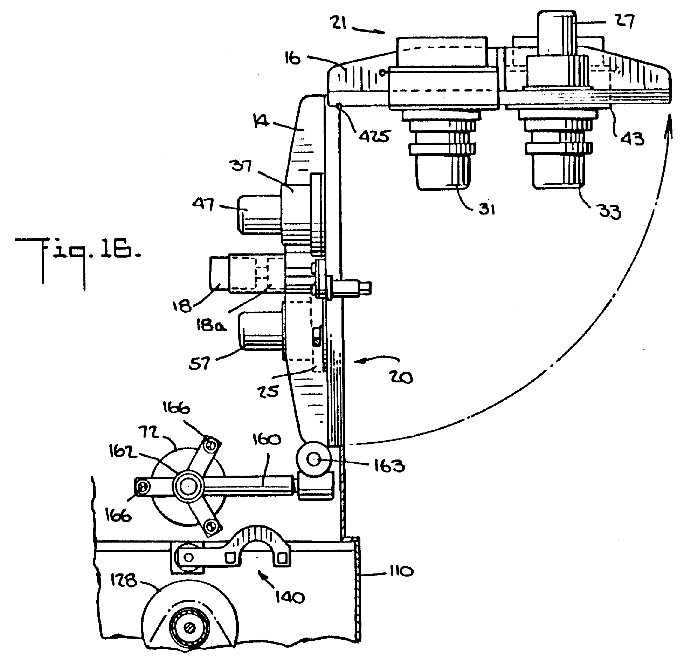

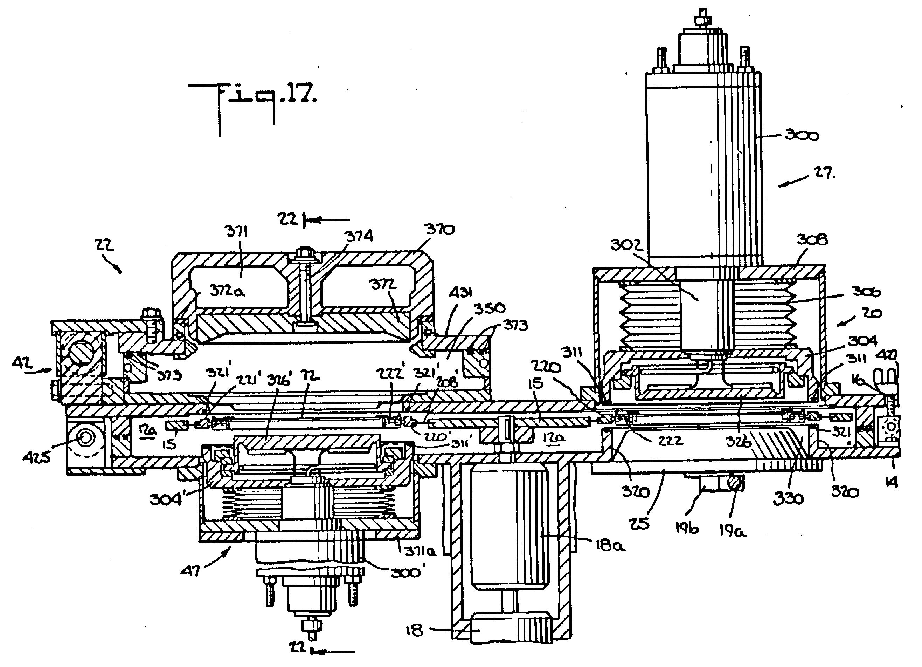

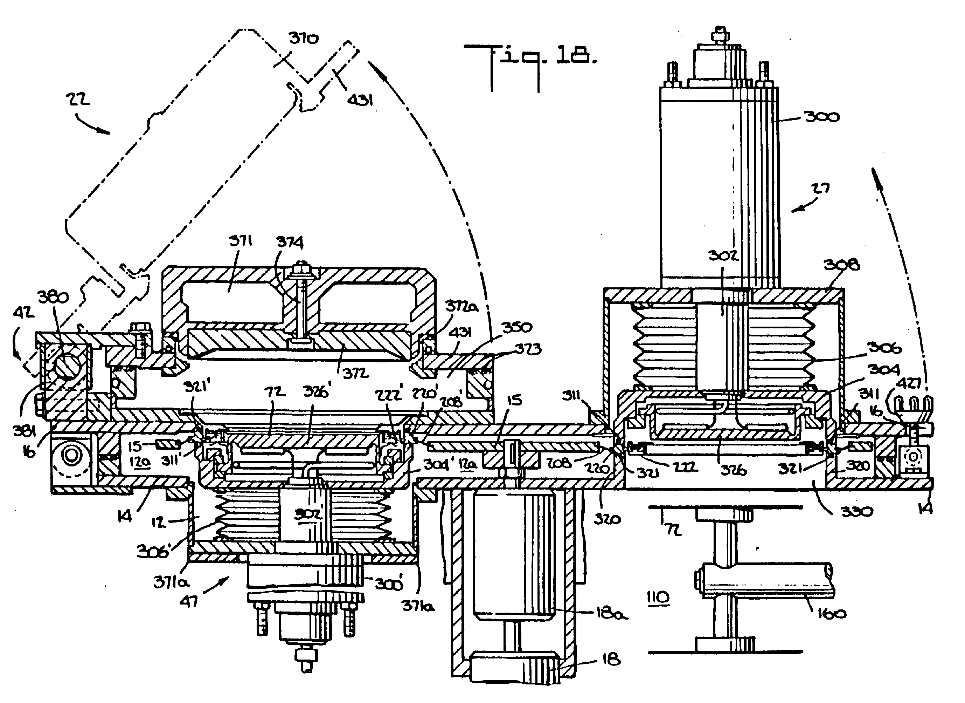

Each of stations 20, 21, 22 and 23 includes a first section mounted on chamber half 14 and a second opposing portion mounted on chamber half 16. This is shown most clearly when viewed in conjunction with the top views of FIGS. 14 and 15, in the side views of FIGS. 2 and 26 and in the rear view of FIG. 27. As shown in FIGS. 14 and 15, chamber half 14 includes the load-lock door 25 at station 20, shown opened in FIG. 15 and closed in FIG. 14. The rear portion 16 of chamber 12 at station 20 includes a front-plane device 27, the purpose of which will be explained in greater detail below. At station 21, which, in the illustrated embodiment, is an etching station, but may be a sputtering station, e.g., a back-plane device 37 is attached to chamber half 14, and chamber half 16 has attached thereto manifold 41 and pump 31, which overlaps the top of the chamber 12. Back-plane device 37 is similar to front-plane device 27. At station 22, which may comprise a sputtering station, a further back-plane device 47 is provided, which may be disposed directly below the back-plane device 37. This can be seen most clearly in FIGS. 1 and 2. The chamber portion 16 as shown in FIG. 1 and FIG. 25, has mounted thereto manifold 42 and pump 32, which extends below the chamber 12, and which cannot be seen in FIG. 14. At station 23, which also may be a sputtering station like station 22, chamber half 14 comprises a further back-plane device 57 and chamber portion 16 has mounted thereto manifold 43 and associated vacuum pump 33, as shown in FIG. 1 and FIG. 25. Again, vacuum pump 33 is disposed below the chamber 12 via the manifold 43. The two chamber halves 14 and 16 are hinged together at 425 and a locking mechanism, e.g., a screw fastener, is provided at 427. See FIG. 25. At least one seal 426 is provided, e.g., O-ring seals as shown in FIG. 26 for sealing the two chamber halves together. FIG. 16 shows the two chamber halves in the opened position. As shown, the various vacuum pumps and manifolds open together with chamber half 16. Also, as shown in FIG. 18 and 27, each of the manifolds define a door which is hinged at 380, allowing access to the interior of the work station without requiring opening of the main chamber 12.

A manifold 40a is attached to chamber half 14. Manifold 40a allows vacuum from a main cryogenic vacuum pump 40d to be supplied to main chamber volume or plenum 12a and to load-lock station 20, as necessary. Before pump 40d is activated, a mechanical vacuum pump (not shown) is utilized to bring the vacuum down in the plenum 12a or the load lock 20 to a specified vacuum level close to the desired final level. A fitting 33d is provided for this purpose. See FIG. 25. Pump 40d then is used to provide the final desired vacuum level. As will be explained later, manifold 40a includes a valve 40b which allows communication with main volume 12a, and valve 40c which allows communication with the volume defined by the load-lock station 20.

Although not shown in the drawings suitable power supplies for biasing the cathode assemblies of the processing stations and the substrates are also provided. Furthermore, R.F. power supplies may also be provided behind the back-plane devices 37, 47, and 57 for improving step coverage desposition on the substrates.

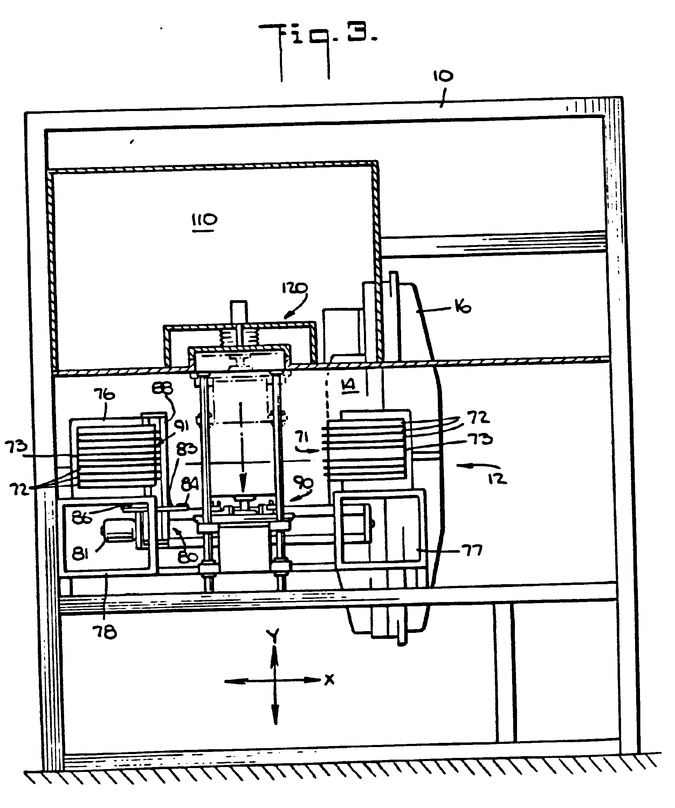

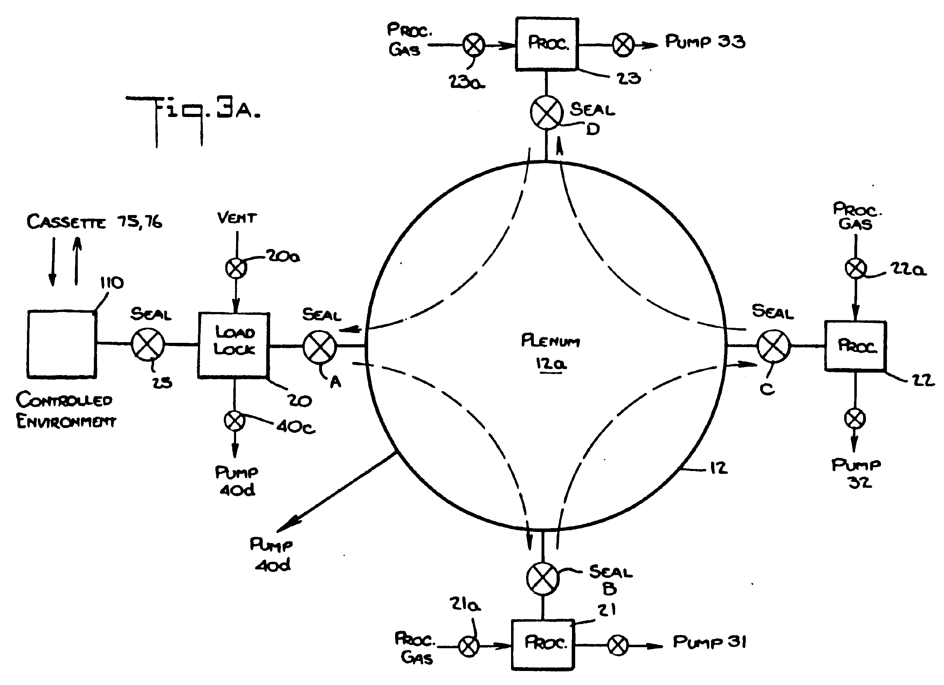

As shown in the drawing figures, the apparatus includes a wafer receiving section, indicated generally at 70, a wafer alignment, centering and lift means 90, a controlled environment chamber 110 having an intermediate load-lock indicated generally at 120, a transfer arm 140 disposed in chamber 110 for receiving and delivering a wafer from or to the intermediate load-lock 120, and for transferring a wafer to or from a load-lock arm 160, which transfers a wafer, whether processed or unprocessed, to or from the main load-lock station 20 of chamber 12. Receiving station 70 includes a cassette 75 holding a plurality of wafers to be processed and/or wafers which have already been processed by the apparatus of the invention. A pick and place mechanism 80 transfer wafers between cassette 75 and alignment, centering and lift means 90. See FIGS. 2, 3 and 4. Two cassettes 75 and 76 may also be used. See FIG. 4. As indicated, mechanisms 80, 90, 120, 140 and 160 are bi-directional, i.e., unprocessed wafers from section 70 are transferred to chamber 12 by these mechanisms and processed wafers are returned to section 70 by the same mechanisms.

FIG. 3A is a schematic representation illustrating the overall operation of the apparatus according to the present invention. Substrates to be processed are supplied from one of two cassettes 75 or 76 into the controlled environment 110 via intermediate load-lock 120. The substrate is then transferred into load-lock 20. A sealing member, for example, load-lock door 25, isolates load-lock 20 from the controlled environment. A valve 20a is utilized to vent the load-lock to the controlled environment so that the load-lock door 25 can be opened to the controlled environment 110 to allow the substrate to be received in the load-lock 20. A mechanical pump (not shown) and cryogenic pump 40d are utilized to evacuate the load-lock 20 via suitable valves including valve 40c, once load-lock door 25 is closed. A sealing member A, to be described in greater detail below, seals the load-lock 20 from the plenum 12a, and opens the plenum 12 to the load-lock once the load-lock has been evacuated to the vacuum level existing in the plenum 12a.

As will be explained in greater detail below, the plenum 12a, defined by chamber 12, is utilized to transfer the articles to be processed from one processing chamber to another. The processing chambers are shown at 21, 22 and 23. The plenum 12a itself, however, is not utilized to perform process steps, such as sputtering or etching. Rather, the substrates are transported through the plenum and transferred to at least one of the processing chambers, where the process step is performed. In accordance with the invention, an article to be processed need not be processed serially, as the apparatus of the present invention allows an article to skip a particular process chamber, for example. Assuming that the article is to be processed in all process chambers, however, the article is isolated from plenum 12a via sealing member B and then supplied to process chamber 21. Pump 31 (and associated mechanical vacuum pump) is utilized to evacuate the process chamber 21 and a valve 21a provides process gas to the process chamber 21. If further processing of the article is to occur after processing in process chamber 21, the article may be transferred to process chamber 22 through a sealing member C, as shown. Pump 32 (and associated mechanical vacuum pump) is utilized to evacuate process chamber 22 and process gas is supplied to the process chamber 22 via valve 22a. If further processing is to occur, the article may be transferred to process chamber 23 through a sealing member D. A pump 33 (and associated mechanical vacuum pump) is utilized to evacuate process chamber 23 and process gas is provided to the chamber 23 via valve 23a. In the illustrated embodiment, three process chambers are shown, although more or fewer process chambers could be provided. After the article has been processed in process chamber 23, it is again supplied back to the load-lock 20 via sealing member A. The article is then returned via sealing means 25 to the controlled environment 110 and returned to the cassettes 75 and 76.

Accordingly, the apparatus shown schematically in FIG. 3A allows isolation of each process chamber 21, 22 and 23 from the other process chambers and also from the main plenum 12a. This prevents cross-contamination between processes being performed in the different process chambers. Furthermore, the apparatus shown allows essentially random access to the different process chambers. Therefore, it is not necessary that the article to be processed enter each process chamber. Rather, the article to be processed can skip a process chamber if that particular process is not to be performed on the article. Additionally, the process to be performed in a particular process chamber can be changed without affecting the other process chambers, because of the isolation provided by seals B, C and D which isolate each process chamber from the others and the plenum 12a.

Furthermore, each process chamber 21, 22 and 23 is essentially independent of the other process chambers, having its own pumps, valves, gas inlets and processing means, so that if one processing chamber ceases to function for some reason, the other chambers are not affected. The gas inlets to each process chamber are shown in FIG. 25 at 21a, 22a and 23a.

The structure of sealing members A, B, C and D will be described in greater detail below, and forms an important part of the invention. In the embodiment shown in the drawings, sealing members A, B, C and D comprise sealing ring members and resilient spring means which hold the article in position during processing and also provide the necessary motion and sealing action between the process chamber and the plenum 12a. Although separate sealing members A, B, C and D are shown in FIG. 3A, in an actual embodiment of the device, the same sealing member is used to seal the different process chambers once a substrate enters the plenum 12a, as the sealing members perform not only a sealing function but also hold the substrate in position during its movement in the plenum 12a. More than one substrate, can, of course, be processed in chamber 12 at one time, and accordingly, a plurality of sealing members, one of which is associated with a respective process chamber at a particular point in time, may be provided. This will be explained in greater detail below.

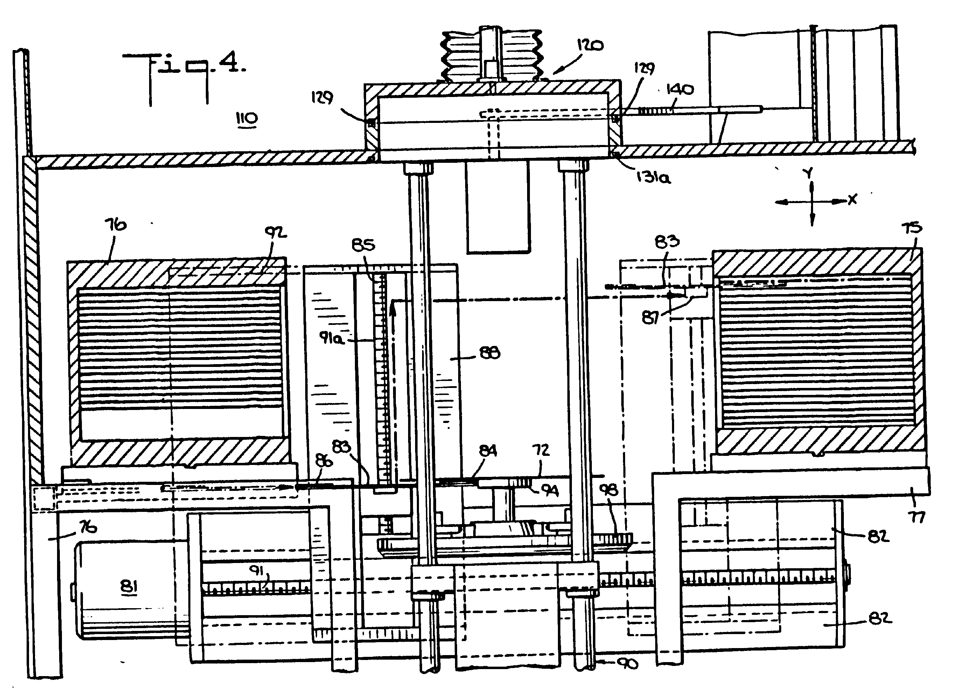

The operation of the invention will now be described in greater detail. With particular reference to FIGS. 3 and 4, the apparatus of the present invention may include one cassette 75 or two cassettes 75 and 76 holding a plurality of stacked wafers 72. Although the cassettes are shown to be substantially horizontal in the drawings, they may have a slight inclination from the horizontal so that the open ends of the cassettes, shown in FIGS. 1 and 3 and identified with reference numeral 71, are slightly raised from closed side 73. In this way, sliding of the wafers in the cassettes 75 or 76 so that they fall out of the open ends 71 is prevented. Cassettes 75 and 76 are mounted on frames 77 and 78, respectively. A pick and place mechanism 80, which is movable in both X and Y axes, shown in FIG. 3 and more clearly in FIG. 4, is provided for retrieving unprocessed wafers from the cassettes and for inserting processed wafers into the cassettes. Pick and place mechanism 80 is driven by a motor 81 and a suitable linkage, for example, along tracks 82. Pick and place mechanism 80 includes a movable arm 83 having suitable grasping mechanisms, e.g., vacuum chucks 84 and 86, disposed at ends of the arm. This is shown more clearly in FIGS. 4 and 5. Arm 83, as shown in FIG. 5, is fastened to a second cross arm 87, which is mounted to member 88, member 88 being slidable in the X direction along tracks 82. Arm 87 is slidable in a track 85 in member 88 in the Y direction. Motor 81 drives via a first screw 91 member 88 and thus arm 87 in the X direction and also via a second screw 91a or other suitable linkage in the Y direction.

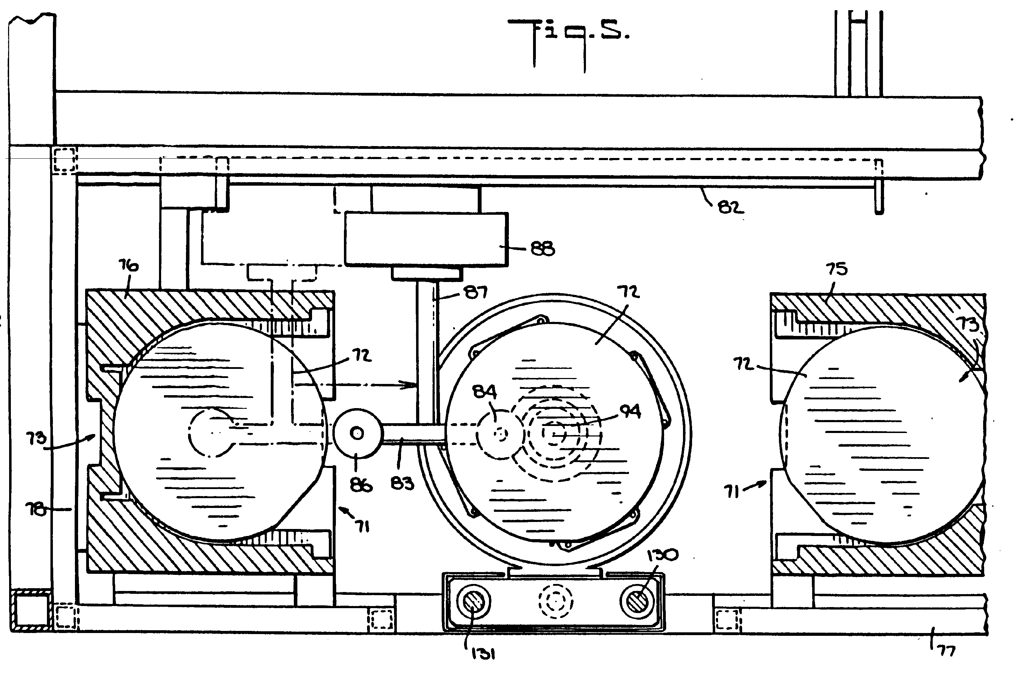

The sequence of operation of pick and place mechanism 80 is shown in FIGS. 4 through 7. FIG. 4 shows a wafer 72 on alignment and lifting mechanism 90. The wafers may comprise, e.g., 6 or 8 inch silicon semiconductor substrates. Alignment and lifting mechanism 90 includes a vacuum chuck 94. The processed wafer 72 has been removed from chamber 12 of the machine. Pick and place mechanism arm 83 is driven from its prior position, which is shown by the phantom line in FIG. 4 at 92, so that vacuum chuck 84 is just below the lower surface of substrate 72 on vacuum chuck 94. Vacuum chuck 94 at this point is deactivated and vacuum chuck 84 activated, so that wafer 72 is picked up by vacuum chuck 84. Arm 83 is now driven horizontally to the left and then vertically upward and to the right to the position adjacent cassette 75 at which the processed wafer is to be inserted. This is shown by the position of the arm 83 shown in phantom near cassette 75 in FIG. 4. Arm 83 is then driven further in the X direction so as to place the substrate into a slot of the cassette. As an example, the last, or top slot of cassette 75 has been chosen in FIGS. 4 and 6. As shown in FIG. 6, once a processed wafer has been inserted into the last position in cassette 75, arm 83 is driven to the left in the X direction, as shown by the arrow 83a, and then vertically downward to a position adjacent cassette 76 so that an unprocessed wafer can be picked up by vacuum chuck 86. If the last position of cassette 75 had not been reached, arm 87 would have moved upward one position to retrieve the next wafer (unprocessed) in cassette 75. Assuming only processed wafers remain in cassette 75, however, arm 87 traverses to cassette 76 to remove an unprocessed wafer. Each cassette 75 and 76 can at any time contain both processed and unprocessed wafers. It is not necessary that one cassette contain only processed wafers and the other cassette unprocessed wafers.

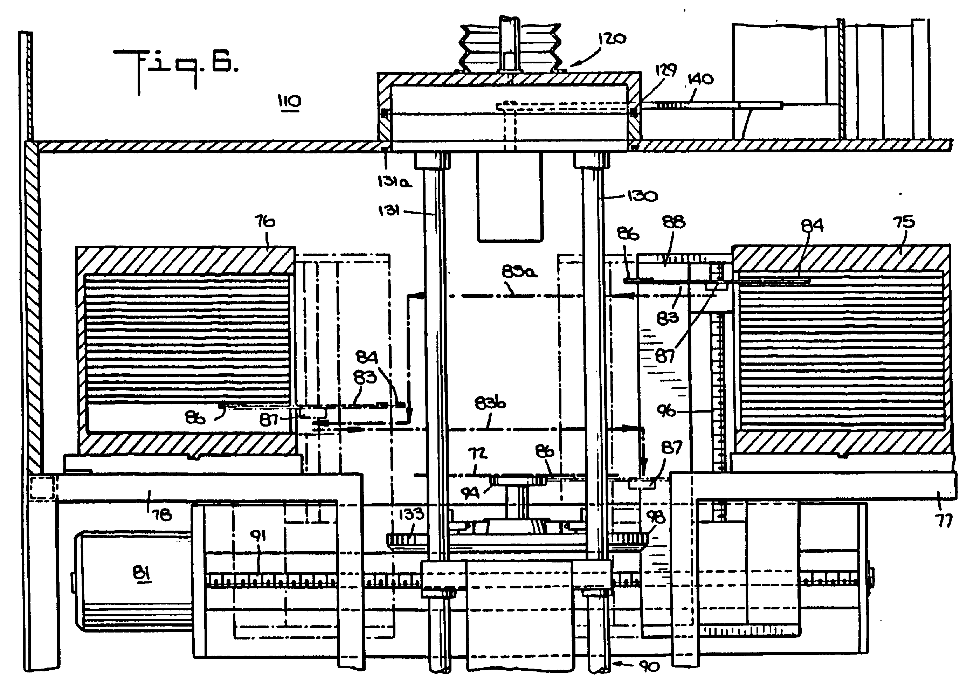

Assuming that a processed wafer has been placed in the uppermost position of cassette 75, the arm 83 will travel to the left in FIG. 6 as shown, and then vertically downward to a position adjacent the sixth position from the bottom of cassette 76. (Assuming five wafers have already been removed from cassette 76 and are now in chamber 12 and on load-lock arm 160 -- to be explained in greater detail later.) Accordingly, arm 83 moves so that vacuum chuck 86 enters the cassette 76 to remove an unprocessed wafer therefrom. Arm 83 then moves in the X direction to the right as shown by the arrow 83b, and then moves downwardly in the vertical direction to a position adjacent the right side of the vacuum chuck 94. Vacuum chuck 94 is now activated and vacuum chuck 86 deactivated. Accordingly, wafer 72 is left in the position shown by the dotted lines on top of vacuum chuck 94. Arm 83 then moves to the right to the home position 83c shown in FIG. 7, so it is out of the way of vacuum chuck 94.

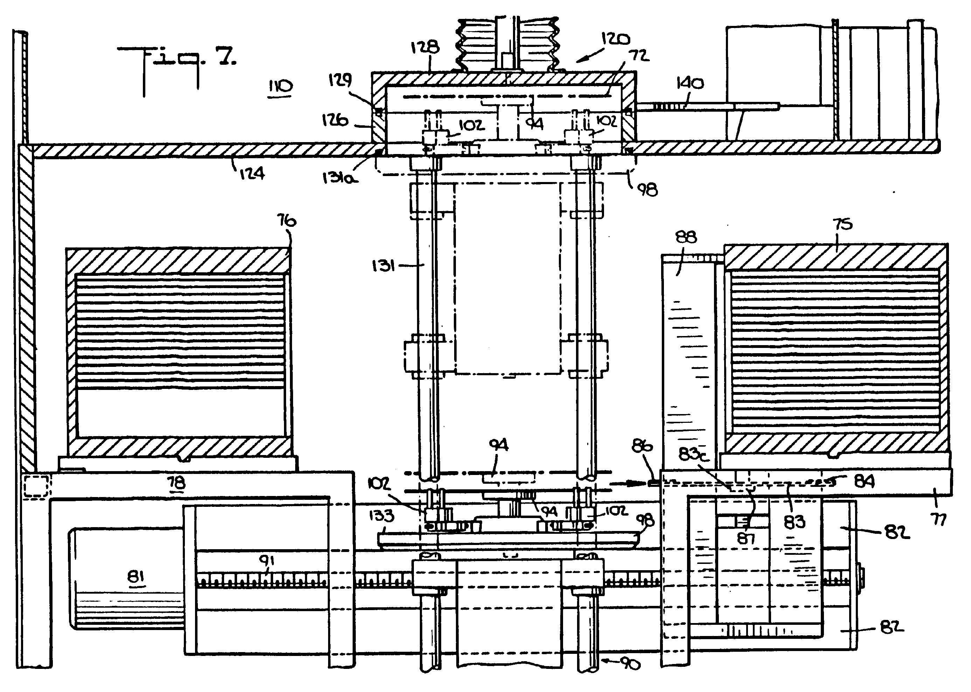

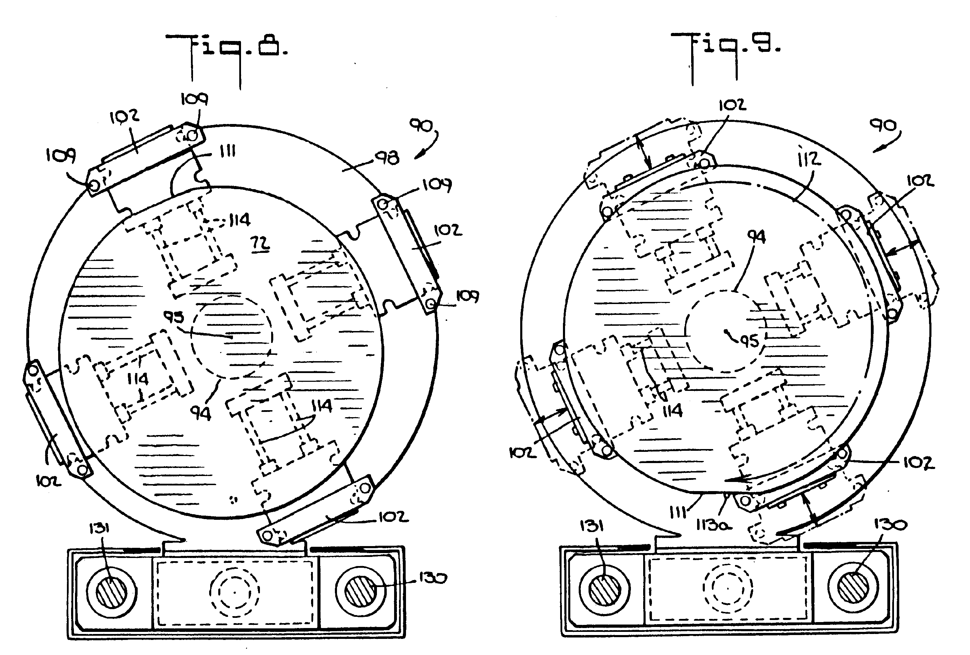

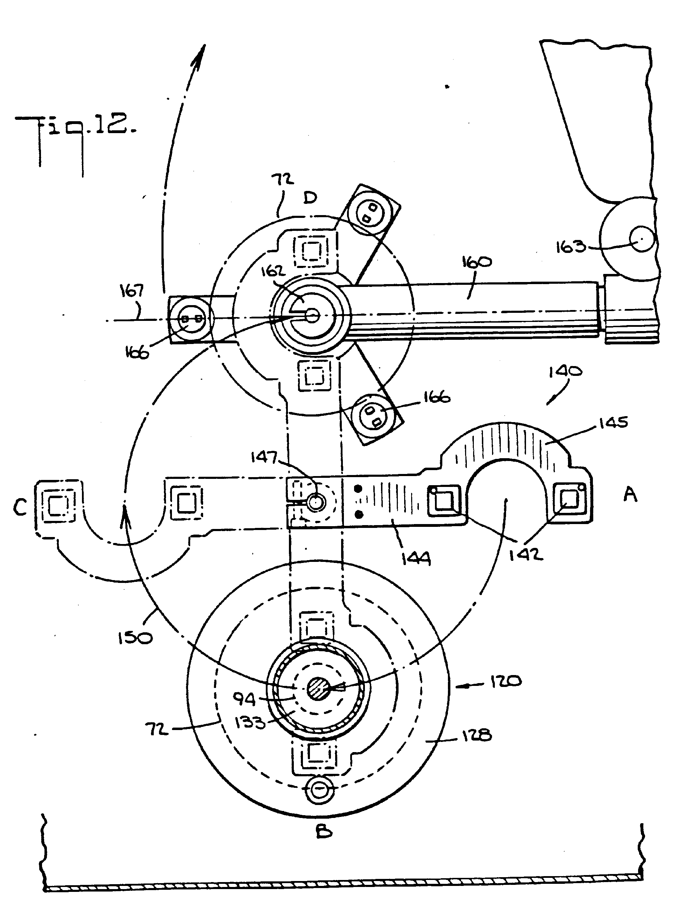

As shown in FIG. 8, a wafer 72 may be placed on vacuum chuck 94 slightly off center from the center 95 of vacuum chuck 94. It is necessary to align the center of the substrate with the center 95 of vacuum chuck 94. Accordingly, lifting table 90 includes an aligning means comprising four radially disposed movable members 102 mounted on support 98. Radially disposed members 102 include aligning pins 109. When it is necessary to align substrate 72, vacuum chuck 94 moves vertically downward, as shown in FIG. 7. At the same time, vacuum is removed from vacuum chuck 94 and radially disposed members 102 move radially inwardly, as shown in FIG. 9, thus biasing pins 109 against wafer 72 and aligning wafer 72 with the center axis of vacuum chuck 94. The movable members 102 may be guided radially on guide rods 114 or by any other suitable operating mechanism. Wafer 72 may also include an indexing mark or flat spot, for example, flat spot 111. It may be necessary to align the flat spot properly on vacuum chuck 94 so that the wafer is properly inserted into chamber 12. Accordingly, vacuum chuck 94 holding wafer 72 is rotated as shown by arrow 112. Proper orientation of the index mark 111 may be determined by a light source and light sensor, for example, a light source 113 (See FIG. 13) disposed near the intermediate load-lock 120 and a light sensor 113a disposed on support 98. Other indexing marks can be used instead of a flat spot, for example, a small notch in the substrate 72.

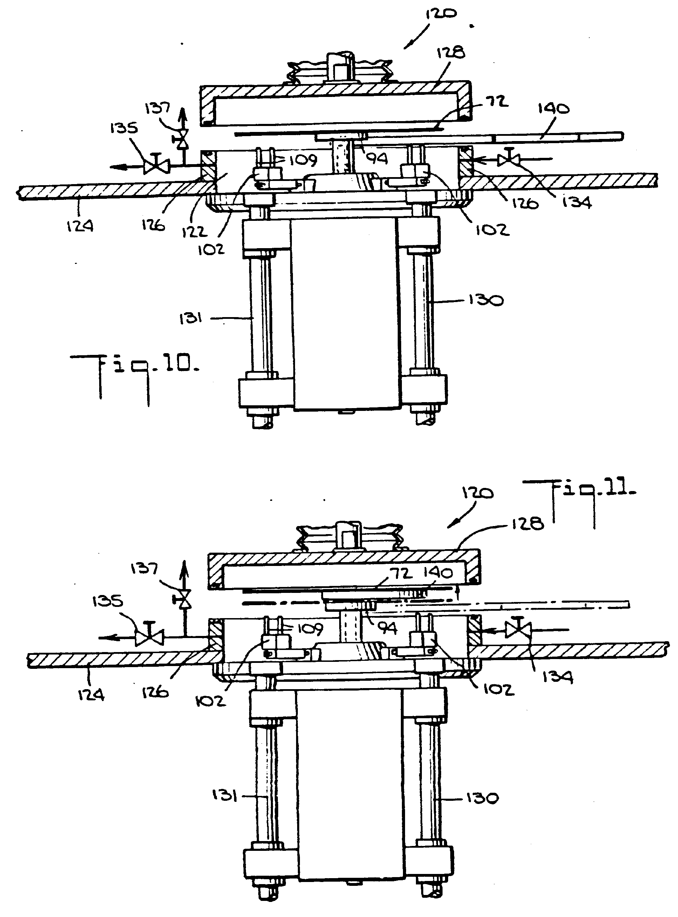

Once the substrate has been centered and aligned, support 98 is driven along guide rails 130 and 131 vertically by a suitable actuating means 132, as shown by the phantom lines in FIG. 7. Substrate 72 is raised into a recess 122 disposed in a housing 124 defining chamber 110 for maintaining a controlled environment therein. Housing 124 includes an aperture therein defined by an upstanding circular wall 126. A top seal cover 128 is movable in the vertical direction, and when in contact with upstanding wall 126, seals controlled environment chamber 110 from the outside via O-ring seals 129. Lift table support 98 includes a sealing surface 133 which seals via O-ring seal 131a with housing 124 when it engages housing 124. The operation of the load-lock thus formed is shown more clearly in FIGS. 10 and 11.

As shown in FIG. 10, the intermediate load-lock 120 is provided in order to maintain the purity of the atmosphere in the controlled environment 110, which essentially may comprise an environment of dry nitrogen gas, as it is desired to prevent as much water vapor and other contaminants as possible from being introduced into the main chamber 12. Accordingly, prior to removing top seal 128, which is movable in a vertical direction as shown, nitrogen gas is introduced via a valve 134 into the volume 122. At the same time, a valve 135 is opened thereby to remove the existing atmosphere in chamber 122. Once dry nitrogen gas has been introduced into chamber 122 for a sufficient period of time and the existing atmosphere has been purged, it is necessary to adjust the pressure in chamber 122 so that it approximates the pressure in the controlled environment 110. Accordingly, a bleed valve 137 is activated to allow the pressure in controlled environment 110 to equalize substantially with the pressure in chamber 122. Once the pressure has equalized, top seal 128 is opened, as shown in FIG. 10, and transfer arm 140, which is shown in greater detail in FIG. 12, enters the opened chamber 122 and vacuum chucks 142 disposed on the transfer arm 140 end section 145 engage the wafer 72 for removing the wafer from chamber 122. See FIGS. 11 and 12. In FIGS. 11 and 12, transfer arm 140 is shown engaging wafer 72. Transfer arm 140 enters chamber 122 slightly below the level of wafer 72, and once in position, moves vertically upward so that vacuum chucks 142 engage wafer 72 and remove it from vacuum chuck 94. Alternatively, vacuum chuck 94 may be allowed to lower instead, thus dropping wafer 72 onto transfer arm 140.

FIG. 12 shows the operation of transfer arm 140 in greater detail. FIG 12 is a top view of the transfer arm 140 and load-lock arm 160. Transfer arm 140 is pivotably mounted as shown at 147 and driven by a motor 143. See FIG. 13. Top seal cover 128 and the mechanism 133 for operating the top seal cover, which may comprise a hydraulic cylinder or other activating device, are shown. See also FIGS. 1, 2 and 13. Transfer arm 140 includes a straight section 144 and a crescent-shaped section 145 having disposed thereon vacuum chucks 142. Vacuum chucks 142 may comprise a recessed groove having a square configuration leading to a vacuum source, as shown. The purpose of transfer arm 140 is to receive unprocessed wafers from vacuum chuck 94 and deliver them to load-lock arm 160 and conversely, to receive processed wafers from load-lock arm 160 and deliver them to vacuum chuck 94. The purpose of load-lock arm 160 is to supply wafers to be processed to the load-lock station 20 of chamber 12 and to retrieve processed wafers from load-lock station 20 and deliver them to a position whereby transfer arm 140 can retrieve them to return them to vacuum chuck 94, which then eventually returns them to cassettes 75 and 76. Load-lock arm 160 is rotatable about pivot point 163 in the plane of FIGS. 14 and 15 and also about an axis 167 as shown.

With reference to FIGS. 15A and 15B, the operation of transfer arm 140 and load-lock arm 160 will now be explained. FIGS. 15A and 15B are a schematic illustration of the positions of load-lock 20, load-lock arm 160, transfer arm 140 and intermediate load-lock top seal 128 during a complete machine cycle. In FIGS. 15A and 15B, "O" designates "open", "C" designates "closed," "U" designates "unprocessed" and "P" designates "processed." With reference to FIGS. 12, 14, 15A and 15B, the operation is as follows. Transfer arm 140 moves from the position shown in FIG. 14 at A to the first intermediate position shown at B in Fig.14, at which it receives a new wafer from vacuum chuck 94. Top seal 128 is open at this time as shown in FIG. 15A(a). Transfer arm 140 continues along the arcuate path defined by the arrows 141 to position C as shown in Fig. 14 and eventually places an unprocessed wafer at a first movable position upon the first engaging means or upper vacuum chuck 162 of load-lock arm 160 at point D at a first location in a first horizontal plane. This is shown in FIG. 15A(a). At this point load-lock 20 at a second location in a second vertical plane that is perpendicular to the first plane is closed and transfer arm 140 moves to point C in FIG. 14. Load-lock arm 160 as shown in FIG. 15A(b) now rotates 180° about longitudinal axis 167, thus placing the unprocessed wafer at the bottom and the processed wafer held by second engaging means at a second moveable position which has already been removed from the load-lock 20 on top. Transfer arm 140 returns to position D shown in FIG. 14 and the processed wafer is now removed by transfer arm 140 as shown in FIG 15A(c), and returned to the intermediate load-lock 120 as shown at FIG. 15A(d), whereby the processed wafer is returned to one of the cassettes 75 or 76 at a third location. The next step, as shown in FIG. 15A(e), is the rotation of load-lock arm 160 90° about axis 167 so that the unprocessed wafer faces away from the load-lock 20. Load-lock 20 now opens as shown in FIG 15A(f), and load-lock arm 160 rotates about pivot 163 90° clockwise so that the empty vacuum chuck of load-lock arm 160 facing load-lock 20 can retrieve a processed wafer from load-lock 20. Once a processed wafer has been engaged by the load-lock arm 160, load-lock arm 160 pivots in a third plane parallel to the first plane counterclockwise 90° as shown in FIG. 15A(g). Accordingly, a processed wafer and an unprocessed wafer are now disposed upon the two vacuum chucks of load-lock arm 160 as shown in Fig 15A(g). Load-lock arm 160 now rotates 180° about axis 167 as shown in FIG. 15B(h), so that the unprocessed wafer faces the load-lock 20. Load-lock arm 160 now rotates 90° about fixed transverse axis or pivot 163 that is perpendicular to the longitudinal axis 167, and the unprocessed wafer which had been placed on the load-lock arm 160 in step 15A(a), is now inserted into load-lock 20 when load-lock arm 160 pivots 90° clockwise around point 163. This is shown at step 15B(i). Load-lock arm 160 pivots about pivot point 163 90° counterclockwise as shown at step 15B(j), and then rotates 90° about pivot point 167 as shown at 15B(k), so that the processed wafer now faces downward. Load-lock 20 is closed at this time, and processing of the wafer inserted into chamber 12 at step 15B(i) has begun. Transfer arm 140 has, in the meantime, engaged a new unprocessed wafer as shown at step 15B(k), and the unprocessed wafer is deposited upon the upper vacuum chuck of load-lock arm 160 as shown at 15B(l), returning the apparatus to the beginning of the cycle, which is the same as that shown in FIG. 15A(a).

Accordingly, load-lock arm 160 provides an efficient and versatile way of transferring wafers between transfer arm 140 and load-lock 20. The rotation of arm 160 about axes 163 and 167 and the provision of two vacuum chucks 162 allow one mechanism, in a minimum amount of time and space, to handle both processed and unprocessed wafers.

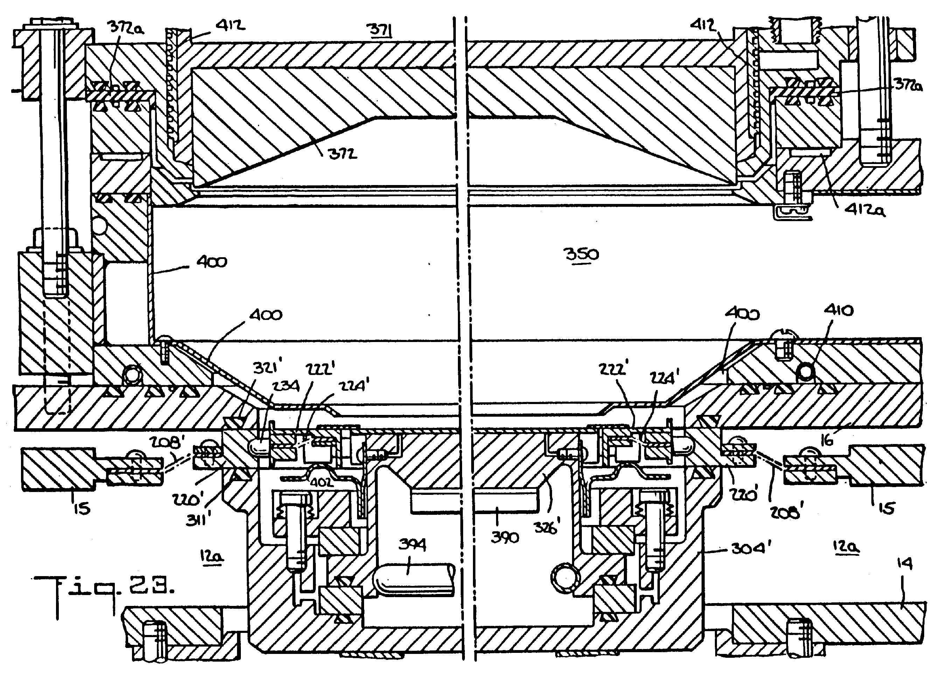

FIG. 17 is a top sectional view of the apparatus through section lines 17-17 of FIG. 2. As shown, a section is taken through both the load-lock station 20 and a sputtering station 22. Load-lock station 20 includes a front-plane device generally indicated at 27 and sputtering station 22 includes a back-plane device generally indicated at 47 and which is similar to front-plane device 27. Chamber 12 defined by chamber halves 14 and 16 includes index plate generally indicated at 15 which is shown in greater detail in FIG. 26. Index plate 15, as shown in FIG. 26, is driven by motor 18 and has four positions, each of which is provided with a substrate holding device as shown in greater detail in FIG. 24.

Before describing the operation of the apparatus with reference to FIGS. 17 through 23, the substrate holding device of FIG. 24 will be described. The substrate holding device forms part of the sealing members A, B, C and D discussed with reference to FIG. 3A, the operation of which will be described in detail below. A portion of the index plate 15 is shown in FIG. 24. Index plate 24 includes four circular cutouts 200 (See FIG. 26), of which one is shown in FIG. 24. A plurality of tabs 202, illustratively three, are provided which extend into the cutout 200. A plurality of arc-shaped flat springs 208, illustratively three, are attached to respective ones of the tabs 202. At the end of the springs 208 farthest from tabs 202, an attachment is made to tabs 214 which extend from an outer ring-shaped sealing member 220. A further inner ring-shaped member 222 is disposed concentrically inside ring-shaped member 220. Ring-shaped member 222 is removably insertable into ring-shaped member 220, and includes a plurality of further spaced arcuate flat springs 224 attached to the ring-shaped member 222 via screws, for example, as shown at 230. At the other ends of springs 224, spring detent members 234, mounted in blocks 235, are disposed. The detent members engage with recesses 244 in outer ring-shaped member 220 and allow ring-shaped member 222 to be decoupled from ring-shaped member 220. Detent member 234 is made of an insulating material such as ceramic or a high temperature plastic material so that the ring 222 and substrate 72 can be insulated from the remainder of the apparatus. This allows the substrate 72 to be properly biased, for example, for sputtering and etching operations.

Outer ring-shaped member 220 can move perpendicularly to the plane of the index plate 15 with respect to index plate 15, and inner ring-shaped member 222 can move perpendicularly with respect to outer ring-shaped member 220 due to the respective springs 208 and 224. The operation of springs 208 and 224 will be explained in greater detail below. Ring 222 has mounted on the backside thereof tabs 240, which tabs provide a backrest for a substrate 72 held by ring 222. Ring 222 also includes a plurality of substrate securing devices 238, which are engaged by rotatable locking and unlocking devices 166 which are mounted on load-lock arm 160.

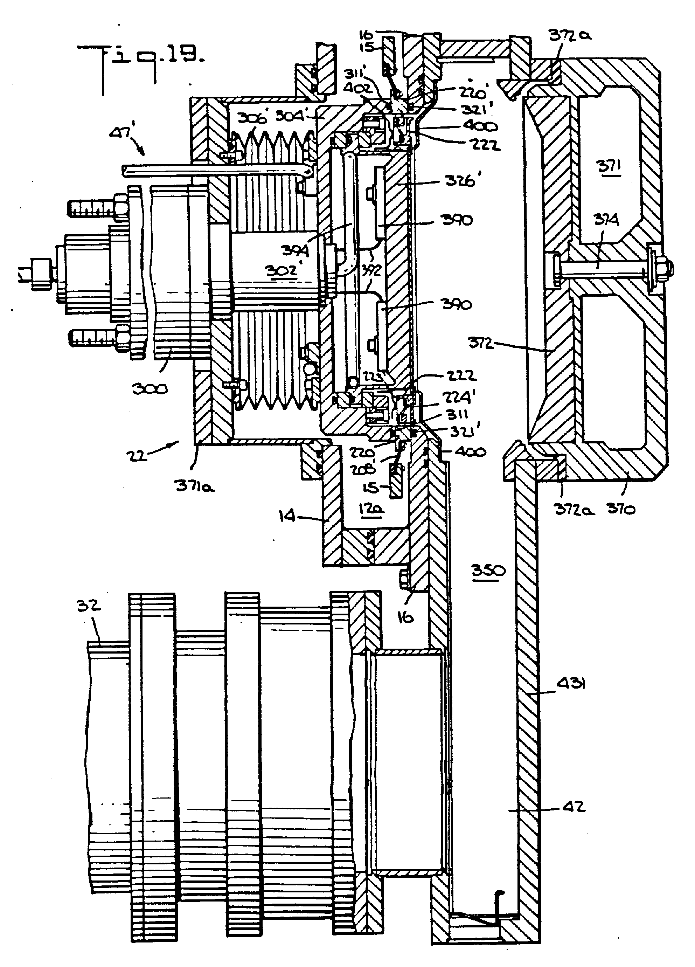

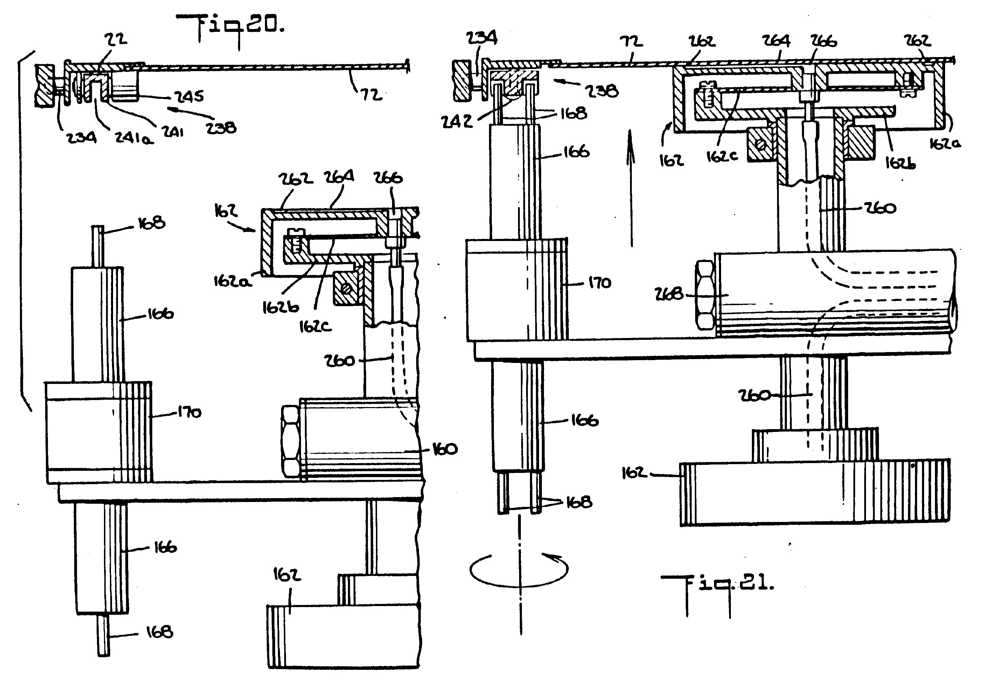

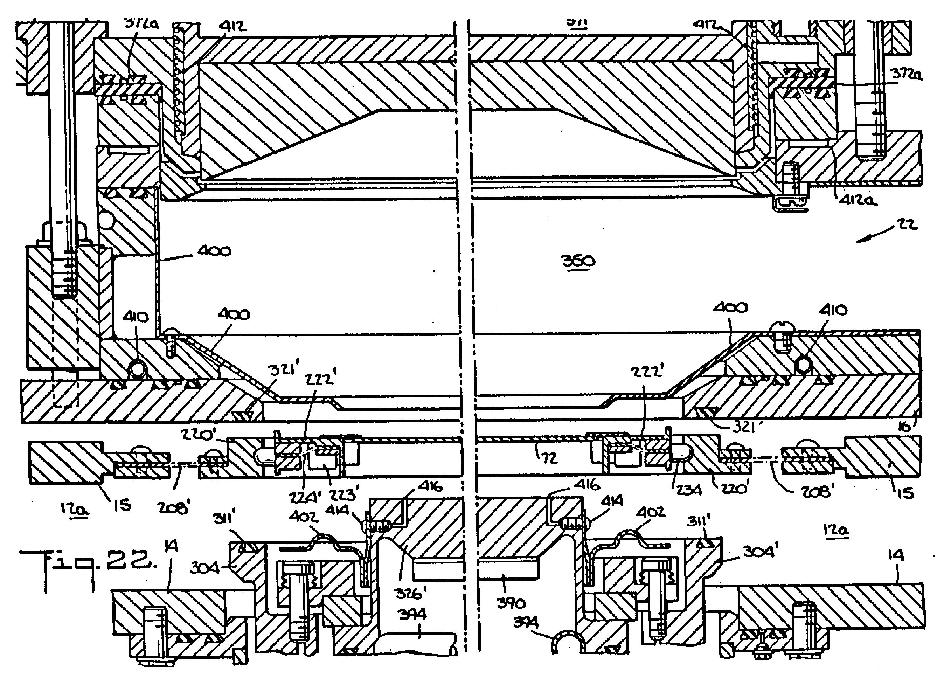

As shown in further detail in FIGS. 20 and 21, securing devices 238 include a roughly channel-shaped member 241 having a slot 241a and a central aperture therein for receiving a screw or other fastener 242. Attached to the channel-shaped member 241 is a retaining member 245, which can be rotated so that it extends into the area occupied by the peripheral edge of substrate 72 once it is positioned inside inner ring 222. Channel-shaped member 241 is fastened in a slot 247, the slot being provided for adjustment of the position of member 241. Channel-shaped member 241 is pivotably mounted on fastener 242. The channel 241a in channel-shape member 241 is engaged by a pair of longitudinally extending rods 168 extending from locking and unlocking device 166. Locking and unlocking device 166 may comprise, for example, a small servo motor 170 or air or hydraulically actuated member. As shown, locking and unlocking device 166 includes rod members 168 at both ends thereof, since load-lock arm 160 is provided with two opposed vacuum chucks 162. As shown in FIGS. 20 and 24, channel-shaped member 241 is disposed so that the slot 241a in the member is generally aligned tangentially with inner ring 222 when substrate 72 is clamped in place. Accordingly, member 245 is disposed so that it extends over the edge of the substrate 72 and substrate 72 is firmly held between tabs 240 of ring 222 and members 245. When the load-lock arm 160 is to remove a substrate from the load-lock station 20, vacuum chuck 162 approaches the substrate 72. At the same time, unlocking device 166 approaches channel-shaped member 241 so that the rods 168 are in alignment with the slot 241a in channel-shaped member 241. As vacuum chuck 162 engages the substrate 72, the rods 168 of locking and unlocking device 166 engage with the slot 241a in channel-shaped member 241. Once vacuum chuck 162 has engaged wafer 72 and rods 168 are engaged in the slot 241a in channel member 241, servo mechanism 170 is actuated to rotate rods 168 90°, as shown in FIG. 21. In this way, member 245 slides in an arcuate path so that it is no longer disposed over the edge of substrate 72. In the illustrated embodiment, three securing members 238 are provided spaced equidistantly around ring member 222, and accordingly, three locking and unlocking members 166 are provided. Therefore, all three members 245 are rotated out of the way at the same time. Accordingly, substrate 72 can be removed by vacuum chuck 162.

When a substrate 72 is being placed in chamber 12, locking and unlocking members 166 rotate members 245 in the opposite direction so as to secure the wafer to the ring-shaped member 222.

Vacuum chuck 162 is illustrative of the vacuum chucks generally used throughout the apparatus of the invention. Generally, vacuum chucks 162 are supplied via vacuum supply lines 260. The face of the vacuum chuck includes an annular depression 262 and at least one lead-in line 264 to depression 262 from a central aperture 266. As shown in FIG. 21, load-lock arm 160 is rotatably disposed on a shaft 268, so that either one of the vacuum chucks 162 can enter the load-lock station 20 as discussed with respect to FIGS. 15A and B.

Preferably, vacuum check 162 comprises a first member 162a which engages the substrate 72 and a second inner member 162b. Members 162a and 162b are coupled via a flat spring member 162c which allows member 162a to move transversely to member 162b, thus allowing member 162a to conform to the plane of the substrate being engaged.

With reference now to FIGS. 17 and 18, FIG. 17 shows load-lock station 20 to the right with load-lock door 25 closed. FIG. 18 shows load-lock door 25 in the open position. FIGS. 17 and 18 show index plate 15 rotatably mounted in chamber 12 defined by chamber halves 14 and 16. As shown in FIGS. 17 and 18, front-plane device 27 at load-lock station 20 may comprise a motor or hydraulically or air actuated member 300 mounted to support 308. The shaft 302 of member 300 is mounted to a first sealing member 304. Sealing member 304 preferably comprises a cup-shaped member and a bellows 306 may be provided to protect shaft 302 extending between support member 308 and cup-shaped member 304 and also to provide sealing. Cup-shaped member 304 includes a first sealing surface disposed annularly around the rim thereof, and may comprise, e.g., an O-ring seal 311. Seal 311 of member 304 engages with a machined surface of outer ring-shaped member 220. Both surfaces of outer ring-shaped member 220 are machined so as to provide a sealing surface, and the other surface of ring-shaped member 220 engages with a sealing surface of an annular extending portion 320 of chamber half 14. An O-ring seal 321 may be provided on portion 320. As will be explained in greater detail later, the O-ring seals 311 and 321 are provided for maintaining the environment in the load-lock station 20 area 330 or the chambers of each of the other processing stations 21, 22, or 23 isolated from main chamber volume 12a. Coupled to an inner portion of cup-shaped member 304 is a support member 326 which is movable along with cup-shaped member 304 to provide support for substrate 72. Because substrate 72 is held firmly by ring-shaped member 222 which is attached to ring-shaped member 220 via flat springs 224, substrate 72 can move transversely to the plane in which it is disposed by a small amount without damage when member 326 moves toward substrate 72. Although member 326 may be arranged so that it contacts substrate 72, in the preferred embodiment, member 326 only comes into close proximity with substrate 72. At the load-lock station 20, front-plane member 326 is provided with heat sources for heating the entering substrate 72, shown in FIG. 18. This may be performed by suitable electric heaters 390. Vacuum chucks 162 of load-lock arm 160 can then move in once load-lock door 25 has been opened, to engage or release a substrate and to lock or unlock securing members 238 and thus secure or release substrate 72.

With respect to FIGS. 1 and 2, load-lock door 25 is actuated by a suitable mechanism 19 via a shaft 19a pivotably mounted to the door 25 at 19b. Mechanism 19 may comprise, e.g., a motor driven gear rack or a suitable air or hydraulic cylinder.

As shown in FIGS. 17 and 18, the apparatus of the present invention isolates main chamber volume 12a from the area 330 defining the load-lock. Accordingly, once chamber 330 has been isolated from main chamber 12, as shown in FIG. 18, the atmosphere in chamber 330 may be purged via a valve member (not shown), and the pressure in chamber 330 equalized with that of the controlled environment 110 existing on the other side of the load-lock door. Once the pressures have been equalized, the load-lock door can be opened, and vacuum chuck 162 of load-lock arm 160 can enter the load-lock area 330 to pick up or release the substrate 72, depending upon whether a processed substrate is being removed or an unprocessed substrate inserted. This is shown in FIG. 18. As shown in FIG. 18, springs 208 which couple index plate 15 and outer ring 220, allow ring-shaped member 220 and thus the inner ring 222 and substrate 72 itself to move outwardly toward the load-lock door 25 so that the mentioned sealing of the area 330 defined by the cup-shaped member 304, ring-shaped member 220 and extending member 320 of chamber half 14 can be accomplished.

After a substrate 72 is inserted into area 330 of load-lock 20, load-lock door 25 is closed and the area 330 pumped by a mechanical vacuum pump (not shown) and then by vacuum pump 40d. The vacuum level is equalized with the level in volume 12a and then front-plane cup-shaped member 304 moves away from ring-shaped member 220 to allow communication between volumes 12a and 330.

Similar sealing means are employed at each of the other stations 21, 22 and 23 to isolate the main chamber volume 12a from the volume defining the particular station. In FIGS. 17 and 18, like components have been provided with like reference symbols for station 20 and station 22, with the exception that the reference numerals for like already introduced elements of station 22 are provided with primes. For example, as shown in FIG. 17 or 18, which are top sectional views taken through the load-lock station 20 and the sputtering station 22 (shown to the left), as shown by section lines 17 in FIG. 2, the volume 12a is isolated by the seal provided by members 304′, 220′ and the wall of chamber half 16 and associated seals 311′ and 321′. Station 22 as shown in FIGS. 17 and 18, also includes a back-plane device 47, which is similar to front-plane device 27. Stations 21 and 23 include similar devices 37 and 57. Generally, element 326′ is moved toward substrate 72 held by inner retaining ring 222′ which is disposed in outer ring 220′ via flat springs 224′ and detents 234′, the outer ring being fixed to index plate 15 via flat springs 208′ and being engaged by sealing member 304′. Since station 22 may be a sputtering station, station 22 may include a removable cathode support member and cover 370 mounted to manifold 42, to which a target block 372 is affixed via a bolt 374, for example. Other suitable affixing means are shown in copending US-A-4855033 (application Serial No. 07/095100), assigned to the assignee of this application. Target block 372 comprises a usable, expendable material, for example, if aluminum is being deposited onto substrate 72, the target block 372 will comprise a block of aluminum. Designs for target 372 and the cathode area generally are disclosed more fully in copending US-A-4855033 and US-A-4 871 433 (application Serial Nos. 07/095100 and 07/095560), assigned to the assignee of this application, and reference is made thereto for details. As shown in FIG. 18, cathode support member 370 is attached to a door 431 and is hinged at 380 to a support structure 381 coupled to chamber half 16. O-ring seals 373 are provided for sealing manifold 42 to chamber half 16. Accordingly, access can be obtained to the interior of manifold 42 and to the cathode and target assembly, as necessary, without disturbing any other processing stations.

Suitable voltages are applied to target 372 with respect to chamber 12, and target 372 is suitably insulated therefrom by insulator 372a. Additionally, magnetic field generating means for appropriately containing the sputtered plasma in chamber 350 and for providing efficient and uniform deposition on substrate 72 may be provided in area 371 and also near the substrate itself, and reference is made to the above copending applications for details. Furthermore, as already indicated, the substrate 72 may be biased at some suitable voltage, and support ring 222 or 222′ is insulated from the rest of the apparatus by insulating detents 234.

For process uniformity, for example, for uniform step coverage, an electromagnetic or magnet assembly 371a may be provided on the back-plane members of sputtering stations 22 and 23, as shown. The purpose of assembly 371a is to provide substantially uniform ion current density near the substrate 72. Reference should be made to the above identified co-pending US-A-4871433 (application Serial No. 07/095560) for details.

As shown in FIG. 18, back-plane device 47 operates to displace member 326′ so that it engages substrate 72 mounted in support ring 222′. Since support ring 222′ is resiliently mounted due to the flat springs 224′ coupling it to outer ring member 220′, which in turn is resiliently coupled by flat springs 208′ to index plate 15, member 326′ can come into close proximity with substrate 72 without damaging the substrate while at the same time allowing member 304′ to bear against ring-shaped member 220′, which in turn bears against chamber half 16, thereby sealing volume 350 from volume 12a. O-ring seals 311′ and 321′ are provided for maintaining a proper seal. Accordingly, the sputtering operation can now be performed against substrate 72 in chamber volume 350 without contaminating the main volume 12a or contaminating any other station 20, 21 or 23. Once the sputtering operation has been completed, the atmosphere in chamber volume 350 can be purged via vacuum pump 32 and manifold 42, and once the atmosphere in chamber 350 has been purged and the pressures equalized between chamber 350 and chamber volume 12a, back-plane members 304′ and 326′ can be moved out of engagement or proximity with ring-shape member 220′ and substrate 72, respectively, thereby allowing the index plate 15 to rotate the processed wafer 72 to the next station.

FIG. 19 is a more detailed cross-sectional view of station 22 of the present invention taken along lines 19-19 of FIG. 2. Cryogenic vacuum pump 32 and manifold 42 are shown at the bottom of the figure. Back-plane device 47, including actuator 300′ is also shown. In this view, details of the cross-section of wafer holding rings 220′ and 222′ are shown. As shown, inner wafer retaining ring 222′ includes hollow sections 223′ in which springs 224′ are disposed. As shown more clearly in FIG. 19, vacuum pump 32 maintains the proper vacuum level in chamber 350, which is isolated by sealing ring 220′ and the O-ring seals 311′ and 321′ when member 304′ biases ring-shaped member 220′ against chamber half 16. Back-plane member 326′ is provided with electric heater devices 390 which are fed via wire conductors 392. Electric heaters 390 may be necessary in certain instances where it is desired to heat the substrate 72 to an optimum temperature for the particular process being carried out. Additionally, it may also be necessary to cool back-plane member 326′ and member 304′ to maintain the temperature of substrate 72 at a desired temperature. Accordingly, cooling lines 394 and 395 may be provided for passing a cooling fluid through the back-plane device. Also shown in FIG. 19 are shields 400 and 402, which are provided for shielding retaining ring 222′, sealing ring 220′ and associated components from the plasma generated during the sputtering operation in space 350.

FIGS. 22 and 23 show further details of station 22. FIG. 22 shows back-plane member 326′ prior to its coming into close proximity with substrate 72 held by inner ring 222′. FIG. 23 shows ring 220′ after it has been engaged by back-plane member 304′. Back-plane member 326′ is also shown in close proximity with substrate 72. Springs 208′ allow sealing ring 220′ to move toward chamber wall 16. As shown in FIG. 23, springs 208′ have been deflected by the force exerted by member 304′ against ring member 220′. O-ring seals 311′ and 321′ seal volume 12a from volume 350. Springs 224′ allow for slight movement of ring member 222′ and accordingly, substrate 72, with respect to ring 220′, thus preventing damage to substrate 72 when back-plane member 326′ comes into close proximity therewith.

FIGS. 22 and 23 show further details of the cooling means provided at each of the sputtering stations. For example, fluid cooling lines 410 may be provided to cool the support structure in the area of the substrate 72. The various cooling lines are shown in FIG. 25 at 437. Additional cooling lines may be provided in the area of target 372 as shown at 412 and 412a. Furthermore, the various fasteners, for example, screws 414 which fasten shield 402 to back-plane member 326′, generally are provided either with heads with drilled vent holes or the member to which they are fastened is provided with vents 416. Such vents or drilled heads are necessary in order that pockets of air not be trapped beneath the fasteners during assembly, which might otherwise later contaminate the evacuated volumes.

As shown in the drawings, inner ring-shaped member 222′ remains in contact with substrate 72 during the performance of each process step, thus preventing particulate formation and breakage of substrate 72 which might otherwise occur if substrate 72 were transferred between different handling mechanisms.

FIG. 25 is a right side view of the overall apparatus shown in FIG. 1. The overall layout of stations 20, 21, 22 and 23 and the various pumps is shown therein. As shown in FIG. 25, chamber half 16 is hinged to chamber half 14 at 425. Suitable locking devices are provided at 427 and shown in sectional view in FIGS. 17 and 18 to lock chamber halves 14 and 16 together. Further hinges 380 allow each of the right side manifold doors of station sections 21, 22 and 23 mounted to chamber half 16 to be opened, for example, for replacement of targets at stations 22 and 23. A station door is shown at 431, for example, in FIG. 18 and FIG. 25. Suitable locking members 429 can be provided for locking each of the right-side station doors in position. FIG. 18 shows station 22 door 431 holding cathode and target support member and cover 370 in the opened position in phantom view, for example. Member 370 may be secured to the station door by bolts or other suitable locking or fastener members.

In the illustrated embodiment, station 21 is an etching station, and accordingly, a cathode and associated cover is not provided. Also, because station 20 is the load-lock, as shown in FIG. 25, no door need be provided at that station.

In the foregoing specification, the invention has been described with reference to a specific exemplary embodiment thereof.

## Claims

1. Apparatus for moving a wafer-like article (P, U) between a first location (D) and a second location (20) comprising:
a longitudinally extending arm (160) having a longitudinal axis (167), said longitudinally extending arm (160) being pivotable in a first plane about a first axis (163) transverse to said longitudinal axis (167);
and engaging means (162) disposed at an end of said longitudinally extending arm (160) displaced along said longitudinal axis (167) from said first axis (163) such that pivoting of said longitudinally extending arm (160) causes said end at which said engaging means (162) are disposed to define an arcuate path;
characterised in that:
said apparatus is adapted for exchanging processed (P) with unprocessed (U) wafer-like articles, and transferring said articles between said first location (D) and said second location (20), said second location (20) being in a plane perpendicular to the plane of the first location;
said engaging means (162) being rotatable about said longitudinal axis (167) and comprising at least two vacuum chucks (162);
whereby operation of the apparatus effects transfer of a first article from said first location to said second location and transfer of a second article from said second location to said first location by a combination of motion in said first plane and rotation about said longitudinal axis (167).

2. Apparatus according to Claim 1 wherein said end of longitudinally extending arm (160) at which said at least two engaging means (162) are disposed is distal from said first axis (163), the other end of said longitudinally extending arm (160) being proximal with said first axis (163).

3. Apparatus according to Claims 1 or 2 wherein first and second engaging means (162) are disposed on opposite ends of a cross arm extending perpendicular to said longitudinal axis (167).

4. Apparatus according to any one of Claims 1 to 3 wherein said first axis (163) is fixed with respect to said second location (20).

5. Apparatus according to any one of Claims 1 to 4 wherein each of said at least two engaging means (162) is displaced a fixed distance from said longitudinal axis (167).

6. Apparatus according to any one of Claims 1 to 5 further comprising cross arm means extending perpendicularly to said longitudinal axis (167) at said end of said longitudinally extending arm (160) at which said at least two engaging means (162) are disposed, first and second engaging means (162) being disposed on opposite ends of said cross arm means.

7. Apparatus according to any one of Claims 1 to 6 for transporting a wafer-like article between a third location and said first location (D) comprising:
carrier means (75, 76) at the third location for supporting a plurality of said articles (P, U);
means (80, 83) for retrieving an article (P, U) from said carrier means (75, 76) and for placing the article (P, U) on a movable support means (90), said movable support means comprising means for transferring said article (P, U) to a first intermediate position (B);
and transfer arm means (140) movable parallel to said first plane for receiving the article (P, U) from said movable support means (94) at said first intermediate position (B) and for transferring the article (P, U) to said first location (D).

8. Apparatus according to Claim 7 wherein said transfer arm means (140) and said longitudinally extending arm (160) are disposed in chamber means (110) isolated from the external environment, said third location (75, 76) being in the external environment and said first location being in communication with the environment in said chamber means (140).

9. Apparatus according to Claim 8 wherein said movable support means (90) comprises means for vertically moving said article (P, U) to the first intermediate position (B) and further comprising means (102) for centering the article (P, U) with respect to a centre axis (95) of said movable support means (90).

10. A method for exchanging processed (P) with unprocessed (U) wafer-like articles and transferring said articles between a first location (D) and a second location (20), said second location (20) being in a plane perpendicular to the plane of said first location, said method comprising the steps of:
receiving a first article (U) from said first location (D) at a first movable position (162) using a vacuum chuck spaced a fixed distance from a longitudinal axis (167) lying in the first plane;
pivoting said longitudinal axis (167) about a first axis (163) perpendicular to the plane of said first location to carry said first article (U) at said first movable position (162) in a first direction from said first location (D) toward said second location (20);
engaging a second article (P) at said second location (20) at a second movable position (162) using a vacuum chuck spaced said fixed distance from said longitudinal axis (167);
simultaneously rotating both said first and second movable positions (162) and said first and second articles (U, P) about said longitudinal axis (167);
depositing said first article (U) at said second location (20);
pivoting said longitudinal axis (167) about said first axis to carry said first and second movable positions (162) and said second article (P) in a second direction opposite said first direction from said second location to said first location (D);
transferring said second article (P) to said first location (D).

11. A method according to Claim 10 wherein said first axis (163) is fixed with respect to said second location (20).

## Patentansprüche

1. Vorrichtung zum Fördern eines waferartigen Gegenstands (P, U) zwischen einer ersten Position (D) und einer zweiten Position (20), mit einem länglichen Arm (160) mit einer Längsachse (167), der in einer ersten Ebene um eine quer zu der Längsachse (167) liegende erste Achse (163) schwenkbar ist, und Greifmitteln (162), die an einem Ende des länglichen Arms (160), in Richtung der Längsachse (167) versetzt zur ersten Achse (163), angeordnet sind, so daß durch Verschwenken des länglichen Arms (160) das Ende, an dem die Greifmittel (162) angeordnet sind, auf einem Kreisbogen bewegbar ist, **dadurch** **gekennzeichnet**, daß sie für den Austausch von bearbeiteten (P) und unbearbeiteten (U) waferartigen Gegenständen und deren Transport zwischen der ersten Position (D) und der zweiten Position (20) ausgelegt ist, die sich in einer senkrecht zur Ebene der ersten Position liegenden Ebene befindet, und die Greifmittel (162) um die Längsachse (167) drehbar sind und wenigstens zwei Vakuumgreifer (162) aufweisen, wobei der Betrieb der Vorrichtung durch eine Kombination einer Bewegung in der ersten Ebene und einer Drehbewegung um die Längsachse (167) den Transport eines ersten Gegenstands von der ersten zur zweiten Position und den Transport eines zweiten Gegenstands von der zweiten zur ersten Position bewirkt.

2. Vorrichtung nach Anspruch 1, **dadurch** **gekennzeichnet**, daß dasjenige Ende des länglichen Arms (160), an dem die wenigstens zwei Greifmittel (162) angeordnet sind, das von der ersten Achse (163) entfernte Ende ist, während das andere Ende des länglichen Arms (160) sich bei der ersten Achse (163) befindet.

3. Vorrichtung nach Anspruch 1 oder 2, **dadurch** **gekennzeich****net**, daß die ersten und zweiten Greifmittel (162) an gegenüberliegenden Enden eines sich senkrecht zu der Längsachse (167) erstreckenden Querarms angeordnet sind.

4. Vorrichtung nach einem der Ansprüche 1 bis 3, **dadurch** **ge****kennzeichnet**, daß die erste Achse (163) relativ zu der zweiten Position (20) festliegt.

5. Vorrichtung nach einem der Ansprüche 1 bis 4, **dadurch** **ge****kennzeichnet**, daß jedes der wenigstens zwei Greifmittel (162) ein bestimmtes Maß von der Längsachse (167) versetzt ist.

6. Vorrichtung nach einem der Ansprüche 1 bis 5, **gekenn****zeichnet durch** einen sich senkrecht zu der Längsachse (167) erstreckenden Querarm an demjenigen Ende des Längsarms (160), an welchem sich die wenigstens zwei Greifmittel (162) befinden, welche an entgegengesetzten Enden des Querarms angeordnet sind.

7. Vorrichtung nach einem der Ansprüche 1 bis 6 zum Fördern eines waferartigen Gegenstands zwischen einer dritten Postion und der ersten Position (D), **gekennzeichnet** **durch** Lagerorgane (75, 76) in der dritten Position zum Halten einer Vielzahl der Gegenstände (P, U), Mittel (80, 83) zur Entnahme eines Gegenstands (P, U) von den Lagerorganen (75, 76) und zum Absetzen des Gegenstands (P, U) auf einem beweglichen Tragorgan (90), welches Mittel zum Fördern des Gegenstands (P, U) zu einer ersten Zwischenposition (B) aufweist, und einen Übergabearm (140), der parallel zu der ersten Ebene bewegbar ist, um den Gegenstand (P, U) in der ersten Zwischenposition (B) von dem beweglichen Tragorgan (94) zu empfangen und zu der ersten Position (D) zu fördern.

8. Vorrichtung nach Anspruch 7, **dadurch** **gekennzeichnet,** daß der Übergabearm (140) und der längliche Arm (160) in einem von des Ümgebung abgeschlossenen Raum (110) angeordnet sind, wobei sich die dritte Position (75, 76) in der Umgebung befindet und die erste Position mit dem Inneren des Raums (110) in Verbindung steht.

9. Vorrichtung nach Anspruch 8, **dadurch** **gekennzeichnet**, daß das bewegliche Tragorgan (90) Mittel zum senkrechten Fördern der Gegenstände (P, U) zu der ersten Zwischenposition (B) weiterhin Mittel (102) zum Zentrieren der Gegenstände (P, U) relativ zu einer Mittelachse (95) des beweglichen Tragorgans (90) aufweist.

10. Verfahren zum Auswechseln bearbeiteter (P) und unbearbeiteter (U) waferartiger Gegenstände und zum Fördern dieser Gegenstände zwischen einer ersten Position (D) und einer zweiten Position (20), die sich in einer senkrecht zur Ebene der ersten Position liegenden Ebene befindet, **dadurch** **gekennzeichnet**, daß in der ersten Position (D) ein erster Gegenstand (U) an einer ersten beweglichen Halterung (162) aufgenommen wird, wobei ein in einem festen Abstand von einer in der ersten Ebene liegenden Längsachse (167) angeordneter Vakuumgreifer verwendet wird, dann die Längsachse (167) um eine erste Achse (183), die senkrecht auf der Ebene der ersten Position steht, geschwenkt wird, um den ersten Gegenstand (U) an der beweglichen Halterung (162) in einer ersten Richtung von der ersten Position (D) zur zweiten Position (20) zu fördern, dann in der zweiten Position (20) ein zweiter Gegenstand (P) von einer zweiten beweglichen Halterung (162) ergriffen wird, wobei ein in dem festen Abstand von der Längsachse (167) angeordneter Vakuumgreifer verwendet wird, die erste und die zweite bewegliche Halterung (162) und der erste und zweite Gegenstand (U, P) gleichzeitig um die Längsachse gedreht werden, der erste Gegenstand (U) an der zweiten Position (20) abgelegt wird, die Längsachse (167) um die erste Achse verschwenkt wird, um die erste und die zweite bewegliche Halterung (162) und den zweiten Gegenstand (P) in einer zweiten Richtung, entgegengesetzt zur ersten Richtung, von der zweiten zur ersten Position (D) zu fördern, und der zweite Gegenstand (P) an der ersten Position (D) übergeben wird.

11. Verfahren nach Anspruch 10, **dadurch** **gekennzeichnet**, daß die erste Achse (163) mit Bezug auf die zweite Position (20) festliegt.

## Revendications

1. Appareil pour déplacer un article en forme de disque (P, U) entre un premier emplacement (D) et un deuxième emplacement (20) comprenant:
un bras (160) s'étendant longitudinalement et ayant un axe (167) longitudinal, ledit bras (160) s'étendant longitudinalement pouvant pivoter dans un premier plan autour d'un premier axe (163) transversal par rapport audit axe (167) longitudinal;
et des moyens (162) d'engrenage disposés à une extrémité dudit bras (160) s'étendant longitudinalement, déplacé le long dudit axe longitudinal (167) dudit premier axe (163) de telle manière que le fait de faire pivoter ledit bras (160) s'étendant longitudinalement amène ladite extrémité sur laquelle lesdits moyens d'engrenage (162) sont disposés à définir une trajectoire en forme d'arc;
caractérisé en ce que:
ledit appareil est adapté pour échanger des articles en forme de disque traités (P) avec des articles en forme de disque non traités (U) et pour transférer lesdits articles entre ledit premier emplacement (D) et ledit deuxième emplacement (20), ledit deuxième emplacement (20) étant dans un plan perpendiculaire au plan du premier emplacement;
lesdits moyens (162) d'engrenage pouvant pivoter autour d'un axe (167) longitudinal et comprenant au moins deux plateaux de serrage à vide (162);
le fonctionnement de l'appareil effectuant le transfert d'un premier article dudit premier emplacement audit second emplacement et le transfert d'un deuxième article dudit second emplacement audit premier emplacement par une combinaison de mouvement dans ledit premier plan et de rotation autour dudit axe (167) longitudinal (167).

2. Appareil selon la revendication 1 dans lequel ladite extrémité du bras (160) s'étendant longitudinalement, sur laquelle au moins deux desdits moyens d'engrenage (162) sont disposés, est distale dudit premier axe (163), l'autre extrémité dudit bras (160) s'étendant longitudinalement étant proximale dudit premier axe (163).

3. Appareil selon les revendications 1 ou 2 dans lequel les premier et deuxième moyens d'engrenage (162) sont disposés aux extrémités opposées d'un bras transversal s'étendant perpendiculairement audit axe (167) longitudinal.

4. Appareil selon l'une quelconque des revendications 1 à 3 dans lequel ledit premier axe (163) est fixé par rapport audit deuxième emplacement (20).

5. Appareil selon l'une quelconque des revendications 1 à 4 dans lequel chacun desdits au moins deux moyens (162) d'engrenage est déplacé à une distance fixe dudit axe (167) longitudinal.

6. Appareil selon l'une quelconque des revendications 1 à 5 comprenant en outre des moyens de bras transversal s'étendant perpendiculairement audit axe longitudinal (167) à ladite extrémité dudit bras (160) s'étendant longitudinalement sur lequel lesdits au moins deux moyens d'engrenage (162) sont disposés, le premier et le deuxième moyen d'engrenage (162) étant disposés sur les extrémités opposées desdits moyens de bras transversal.

7. Appareil selon l'une quelconque des revendications 1 à 6 pour transporter un article en forme de disque entre un troisième emplacement et ledit premier emplacement (D) comprenant:
des moyens de support (75, 76) au troisième emplacement pour supporter plusieurs desdits articles (P, U);
des moyens (80, 83) pour récupérer un article (P, U) desdits moyens de support (75, 76) et pour placer l'article (P, U) sur un moyen de support mobile (90), ledit moyen de support mobile comprenant des moyens pour transférer ledit article (P, U) dans une première position intermédiaire (B);
et des moyens de bras de transfert (140) pouvant être déplacés parallèlement audit premier plan pour recevoir l'article (P, U) dudit moyen de support mobile (94) dans ladite première position intermédiaire (B) et transférer l'article (P, U) audit premier emplacement (D).

8. Appareil selon la revendication 7 dans lequel lesdits moyens de bras de transfert (140) et ledit bras (160) s'étendant longitudinalement sont disposés dans des moyens de chambre (110) isolés de l'environnement extérieur, ledit troisième emplacement (75, 76) étant dans l'environnement extérieur et ledit premier emplacement étant en communication avec l'environnement dans lesdits moyens de chambre (140).

9. Appareil selon la revendication 8 dans lequel ledit moyen de transport mobile (90) comprend des moyens pour déplacer verticalement ledit article (P, U) vers la première position intermédiaire (B) et comprenant en outre des moyens (102) pour centrer l'article (P, U) par rapport à un axe (95) central dudit moyen de support mobile (90).

10. Une méthode pour échanger des articles en forme de disque traités (P) avec des articles en forme de disque non traités (U) et transférer lesdits articles entre un premier emplacement (D) et un deuxième emplacement (20), ledit deuxième emplacement (20) étant dans un plan perpendiculaire au plan dudit premier emplacement, ladite méthode comprenant les étapes suivantes:
recevoir un premier article (U) dudit premier emplacement (D) dans une première position mobile (162) en utilisant un plateau de serrage à vide placé à une distance fixe d'un axe longitudinal (167) se trouvant dans le premier plan;
faire pivoter ledit axe longitudinal (167) autour d'un premier axe (163) perpendiculaire au plan dudit premier emplacement pour transporter ledit premier article (U) à ladite première position mobile (162) dans une première direction dudit premier emplacement (D) vers ledit deuxième emplacement (20);
engrener un deuxième article (P) audit deuxième emplacement (20) dans une deuxième position mobile (162) en utilisant un plateau de serrage à vide placé à une distance fixe dudit axe longitudinal (167);
faire tourner simultanément lesdites première et deuxième positions (162) mobiles et lesdits premier et deuxième articles (U, P) autour dudit axe longitudinal (167);
déposer ledit premier article (U) audit deuxième emplacement (20);
faire pivoter ledit axe longitudinal (167) autour dudit premier axe pour transporter lesdites première et deuxième positions (162) mobiles et ledit deuxième article (P) dans une deuxième direction opposée à ladite première direction, dudit deuxième emplacement audit premier emplacement (D);
transférer ledit deuxième article (P) audit premier emplacement (D).

11. Une méthode selon la revendication 10 dans laquelle ledit premier axe (163) est fixé par rapport audit deuxième emplacement (20).
